# EUROPEAN PATENT APPLICATION

(11) **EP 4 447 114 A1**
(43) Date of publication of application: **16.10.2024**
(21) Application number: 22903870.8
(22) Date of filing: 18.10.2022
(51) Int. Cl.: H01L 27/146, H01L 21/768, H04N 25/62, H04N 25/76

(54) **IMAGING DEVICE**

(30) Priority: 10.12.2021 JP 2021201282
(71) Applicant: Sony Semiconductor Solutions Corporation, Atsugi-shi, Kanagawa 243-0014 (JP)
(72) Inventor: YAMASHITA, Hirofumi, Atsugi-shi, Kanagawa 243-0014 (JP); HANEDA, Masaki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/038823
(87) International publication number: WO 2023/105936

(57) **Abstract**

An imaging device according to an embodiment of the present disclosure includes: a first substrate including a pixel region including a plurality of sensor pixels that performs photoelectric conversion; a second substrate stacked on the first substrate and including a plurality of readout circuits, the plurality of readout circuits being each provided for every one or more of the sensor pixels and outputting a pixel signal based on electric charge outputted from the sensor pixels; a plurality of first junction electrodes provided on a junction surface of the first substrate with the second substrate and coupled to each of the one or more of the sensor pixels, the plurality of first junction electrodes each having a planar shape having a longitudinal direction in a first direction of the first direction and a second direction that are substantially orthogonal to each other; and a plurality of second junction electrodes provided on a junction surface of the second substrate with the first substrate, coupled to respective ones of the plurality of readout circuits, and coupled to respective ones of the plurality of first junction electrodes, the plurality of second junction electrodes each having a planar shape having a longitudinal direction in the second direction of the first direction and the second direction that are substantially orthogonal to each other.

## Description

### Technical Field

The present disclosure relates to an imaging device.

### Background Art

For example, PLT 1 discloses an imaging device in which a shield electrode is provided between adjacent junction electrodes electrically coupled to floating diffusion layers (floating diffusions: FDs) of respective adjacent sensor pixels to thereby reduce signal interference caused by FD-FD coupling.

### Citation List

### Patent Literature

PLT1: Japanese Unexamined Patent Application Publication No. 2020-88380

### Summary of the Invention

Incidentally, an imaging device of a three-dimensional structure is desired to improve an image quality.

It is desirable to provide an imaging device with a high image quality.

An imaging device according to an embodiment of the present disclosure includes: a first substrate including a pixel region including a plurality of sensor pixels that performs photoelectric conversion; a second substrate stacked on the first substrate and including a plurality of readout circuits, the plurality of readout circuits being each provided for every one or more of the sensor pixels and outputting a pixel signal based on electric charge outputted from the sensor pixels; a plurality of first junction electrodes provided on a junction surface of the first substrate with the second substrate and coupled to each of the one or more of the sensor pixels, the plurality of first junction electrodes each having a planar shape having a longitudinal direction in a first direction of the first direction and a second direction that are substantially orthogonal to each other; and a plurality of second junction electrodes provided on a junction surface of the second substrate with the first substrate, coupled to respective ones of the plurality of readout circuits, and coupled to respective ones of the plurality of first junction electrodes, the plurality of second junction electrodes each having a planar shape having a longitudinal direction in the second direction of the first direction and the second direction that are substantially orthogonal to each other.

In the imaging device according to the embodiment of the present disclosure, the plurality of first junction electrodes is provided on the junction surface of the first substrate with the second substrate and the plurality of second junction electrodes coupled to the respective ones of the plurality of first junction electrodes is provided on the junction surface of the second substrate with the first substrate or on the junction surface of the first substrate with the second substrate in the first substrate and the second substrate that are stacked on each other. The plurality of first junction electrodes is coupled to each of one or more of sensor pixels, and each has a planar shape having a longitudinal direction in the first direction of the first direction and the second direction that are substantially orthogonal to each other. The plurality of second junction electrodes is coupled to the respective ones of the plurality of readout circuits, and each has a planar shape having a longitudinal direction in the second direction of the first direction and the second direction that are substantially orthogonal to each other. Such a configuration increases a distance between adjacent junction electrodes to reduce capacitance between the adjacent junction electrodes.

### Brief Description of the Drawings

[FIG. 1] FIG. 1 is a diagram illustrating a developed perspective configuration example of an imaging device according to an embodiment of the present disclosure.
[FIG. 2] FIG. 2 is a diagram illustrating an example of functional blocks of a logic circuit of FIG. 1.
[FIG. 3] FIG. 3 is a diagram illustrating an example of sensor pixels and a readout circuit of FIG. 1.
[FIG. 4] FIG. 4 is a diagram illustrating a cross-sectional configuration example in a vertical direction of the imaging device of FIG. 1.
[FIG. 5] FIG. 5 is a diagram illustrating a cross-sectional configuration example in a horizontal direction of a first substrate and a second substrate of the imaging device of FIG. 1.
[FIG. 6] FIG. 6 is a diagram illustrating a cross-sectional configuration example in the horizontal direction of junction surfaces of the first substrate and the second substrate of the imaging device of FIG. 1.
[FIG. 7] FIG. 7 is a schematic cross-sectional view in the vertical direction of the imaging device illustrated in FIG. 6.
[FIG. 8] FIG. 8 is a diagram for describing a mode of junction between the first substrate and the second substrate in the imaging device having a cross-sectional configuration illustrated in FIG. 6.
[FIG. 9A] FIG. 9A is a diagram illustrating an example of a wiring layout in the first substrate and the second substrate of the imaging device illustrated in FIG. 1.
[FIG. 9B] FIG. 9B is a diagram illustrating an example of the wiring layout in the first substrate illustrated in FIG. 9A.
[FIG. 9C] FIG. 9C is a diagram illustrating an example of the wiring layout in the second substrate illustrated in FIG. 9A.
[FIG. 10A] FIG. 10A is a diagram illustrating a cross-sectional configuration example in the vicinity of through-wiring lines in FIG. 4.
[FIG. 10B] FIG. 10B is a diagram illustrating a cross-sectional configuration example in the vicinity of the through-wiring lines in FIG. 4.
[FIG. 10C] FIG. 10C is a diagram illustrating a cross-sectional configuration example in the vicinity of the through-wiring lines in FIG. 4.
[FIG. 11A] FIG. 11A is a diagram illustrating a cross-sectional configuration example in the vicinity of the through-wiring lines in FIG. 4.
[FIG. 11B] FIG. 11B is a diagram illustrating a cross-sectional configuration example in the vicinity of the through-wiring lines in FIG. 4.
[FIG. 11C] FIG. 11C is a diagram illustrating a cross-sectional configuration example in the vicinity of the through-wiring lines in FIG. 4.
[FIG. 12] FIG. 12 is a diagram illustrating a cross-sectional configuration example in the horizontal direction of a first substrate and a second substrate according to Modification Example 1 of the present disclosure.
[FIG. 13] FIG. 13 is a diagram illustrating a cross-sectional configuration example in the horizontal direction of the junction surfaces of the first substrate and the second substrate of the imaging device of FIG. 1.
[FIG. 14] FIG. 14 is a schematic cross-sectional view in the vertical direction of the imaging device illustrated in FIG. 13.
[FIG. 15] FIG. 15 is a diagram illustrating a cross-sectional configuration example in the horizontal direction of a first substrate and a second substrate according to Modification Example 2 of the present disclosure.
[FIG. 16] FIG. 16 is a diagram illustrating a cross-sectional configuration example in the horizontal direction of a first substrate and a second substrate according to Modification Example 3 of the present disclosure.
[FIG. 17] FIG. 17 is a diagram illustrating a cross-sectional configuration example in the horizontal direction of a first substrate and a second substrate according to Modification Example 4 of the present disclosure.
[FIG. 18] FIG. 18 is a diagram illustrating a cross-sectional configuration example in the horizontal direction of the first substrate and the second substrate, which is actually envisaged in the imaging device illustrated in FIG. 17.
[FIG. 19] FIG. 19 is a diagram illustrating a cross-sectional configuration example in the horizontal direction of a first substrate and a second substrate according to Modification Example 5 of the present disclosure.
[FIG. 20] FIG. 20 is a diagram illustrating a cross-sectional configuration example in the horizontal direction of the first substrate and the second substrate according to Modification Example 5 of the present disclosure.
[FIG. 21] FIG. 21 is a diagram illustrating a modification example of a circuit configuration of the imaging device of FIG. 1 according to Modification Example 6 of the present disclosure.
[FIG. 22] FIG. 22 is a diagram illustrating an example of a configuration of a sensor pixel and a readout circuit of an imaging device according to Modification Example 7 of the present disclosure.
[FIG. 23] FIG. 23 is a diagram illustrating an example of a configuration of sensor pixels and a readout circuit of an imaging device according to Modification Example 8 of the present disclosure.
[FIG. 24] FIG. 24 is a diagram illustrating an example of a configuration of sensor pixels and a readout circuit of an imaging device according to Modification Example 9 of the present disclosure.
[FIG. 25] FIG. 25 is a diagram illustrating an example of a configuration of sensor pixels and a readout circuit of an imaging device according to Modification Example 10 of the present disclosure.
[FIG. 26] FIG. 26 is a diagram illustrating an example of a mode of a coupling portion between the sensor pixels and the readout circuits of the imaging device illustrated in FIG. 1.
[FIG. 27] FIG. 27 is a diagram illustrating another example of a mode of a coupling portion between sensor pixels and readout circuits of an imaging device according to Modification Example 11 of the present disclosure.
[FIG. 28] FIG. 28 is a diagram illustrating an example of a schematic configuration of an imaging system including the imaging device according to any of the above-described embodiment or modification examples thereof.
[FIG. 29] FIG. 29 is a diagram illustrating an example of imaging steps in the imaging system of FIG. 28.
[FIG. 30] FIG. 30 is a block diagram depicting an example of schematic configuration of a vehicle control system.
[FIG. 31] FIG. 31 is a diagram of assistance in explaining an example of installation positions of an outside-vehicle information detecting section and an imaging section.
[FIG. 32] FIG. 32 is a view depicting an example of a schematic configuration of an endoscopic surgery system.
[FIG. 33] FIG. 33 is a block diagram depicting an example of a functional configuration of a camera head and a camera control unit (CCU).

### Modes for Carrying Out the Invention

Hereinafter, a detailed description is given of an embodiment of the present disclosure with reference to the drawings. It is to be noted that the description is given in the following order.
1. Embodiment (An example of an imaging device in which junction electrodes each having a planar shape having a longitudinal direction in a corresponding one of directions different from each other are provided on respective junction surfaces of a first substrate and a second substrate)
2. Modification Examples
   2-1. Modification Example 1 (Another example of a shape of the junction electrodes)
   2-2. Modification Example 2 (Another example of the shape of the junction electrodes)
   2-3. Modification Example 3 (Another example of the shape of the junction electrodes)
   2-4. Modification Example 4 (Another example of the shape of the junction electrodes)
   2-5. Modification Example 5 (Another example of the shape of the junction electrodes)
   2-6. Modification Example 6 (Another example of a circuit configuration)
   2-7. Modification Example 7 (Another example of a configuration of a pixel sharing unit)
   2-8. Modification Example 8 (Another example of the configuration of the pixel sharing unit)
   2-9. Modification Example 9 (Another example of the configuration of the pixel sharing unit)
   2-10. Modification Example 10 (Another example of the configuration of the pixel sharing unit)
   2-11. Modification Example 11 (Another example of the configuration of the pixel sharing unit)
3. Application Example
4. Practical Application Examples

### <1. Embodiment>

### [Configuration of Imaging Device]

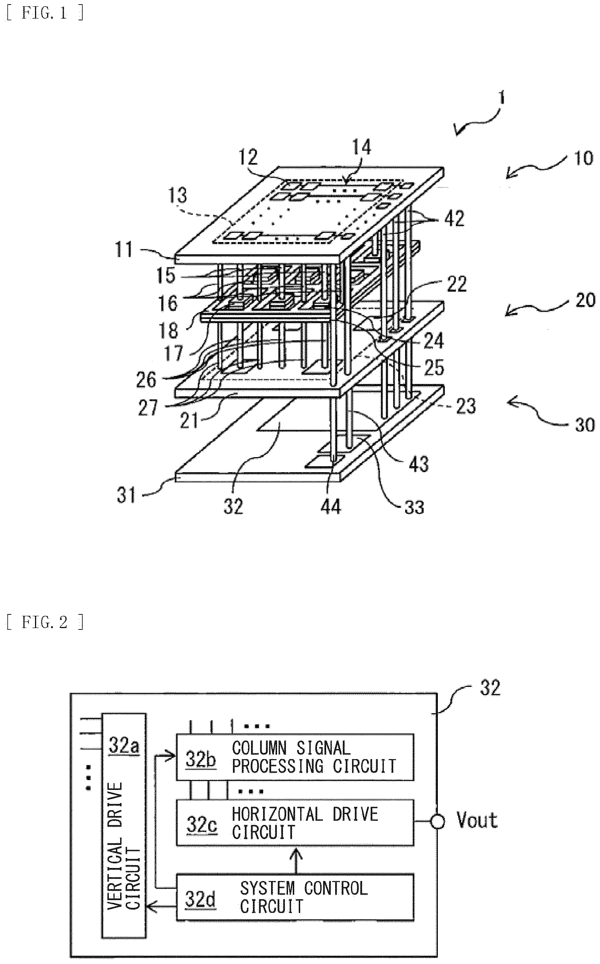

FIG. 1 illustrates an example of a schematic configuration of an imaging device 1 according to an embodiment of the present disclosure. For example, the imaging device 1 includes three substrates (a first substrate 10, a second substrate 20, and a third substrate 30). The imaging device 1 is an imaging device of a three-dimensional structure having a configuration in which the three substrates (the first substrate 10, the second substrate 20, and the third substrate 30) are bonded to each other. The first substrate 10, the second substrate 20, and the third substrate 30 are stacked in this order.

The first substrate 10 includes, in a semiconductor substrate 11, a plurality of sensor pixels 12 that performs photoelectric conversion. The plurality of sensor pixels 12 is provided in a matrix pattern in a pixel region 13 of the first substrate 10. The first substrate 10 includes, for example, a plurality of drive wiring lines 14 extending in a row direction. The plurality of drive wiring lines 14 is electrically coupled to a vertical drive circuit 32a (described later).

The second substrate 20 includes, in a semiconductor substrate 21, readout circuits 22 that output pixel signals based on electric charge outputted from the sensor pixels 12. The readout circuits are provided one by one for every one or more of the sensor pixels 12. The plurality of readout circuits 22 is provided in a matrix pattern in a readout circuit region 23 of the second substrate 20. The second substrate 20 includes, for example, a plurality of drive wiring lines extending in the row direction, and a plurality of vertical signal lines VSL (described later) extending in a column direction. The plurality of drive wiring lines provided in the second substrate 20 is electrically coupled to the vertical drive circuit 32a described later. The plurality of vertical signal lines VSL is electrically coupled to a column signal processing circuit 32b described later.

The third substrate 30 includes, in a semiconductor substrate 31, a logic circuit 32 and a booster circuit 33. The logic circuit 32 controls each of the sensor pixels 12 and each of the readout circuits 22, and processes a pixel signal obtained from each of the readout circuits 22. The logic circuit 32 includes, for example, the vertical drive circuit 32a, the column signal processing circuit 32b, a horizontal drive circuit 32c, and a system control circuit 32d, as illustrated in FIG. 2. The logic circuit 32 outputs an output voltage Vout obtained for each of the sensor pixels 12 to the outside.

The vertical drive circuit 32a sequentially selects the plurality of sensor pixels 12 on a row-by-row basis, for example. The vertical drive circuit 32a is, for example, electrically coupled to the plurality of drive wring lines 14. The vertical drive circuit 32a sequentially selects the plurality of sensor pixels 12 on a row-by-row basis by outputting selection signals in sequence to the plurality of drive wring lines 14.

The column signal processing circuit 32b performs correlated double sampling (Correlated Double Sampling: CDS) processing on a pixel signal outputted from each of the sensor pixels 12 of a row selected by the vertical drive circuit 32a, for example. The column signal processing circuit 32b extracts a signal level of the pixel signal by performing, for example, the CDS processing to hold pixel data corresponding to an amount of light received by each of the sensor pixels 12. The column signal processing circuit 32b is, for example, electrically coupled to the plurality of vertical signal lines VSL described later, and acquires the pixel signal from each of the sensor pixels 12 of the row selected by the vertical drive circuit 32a through the plurality of vertical signal lines VSL. The column signal processing circuit 32b includes, for example, an ADC (analog-to-digital) for each of the vertical signal lines VSL, and converts an analog pixel signal acquired through the plurality of vertical signal lines VSL into a digital pixel signal.

The horizontal drive circuit 32c outputs in sequence, as the output voltage Vout, the pixel data held in the column signal processing circuit 32b to the outside, for example. The system control circuit 32d controls, for example, driving of respective blocks (the vertical drive circuit 32a, the column signal processing circuit 32b, and the horizontal drive circuit 32c) in the logic circuit 32. The booster circuit 33 generates, for example, a power supply potential VDD of a predetermined magnitude.

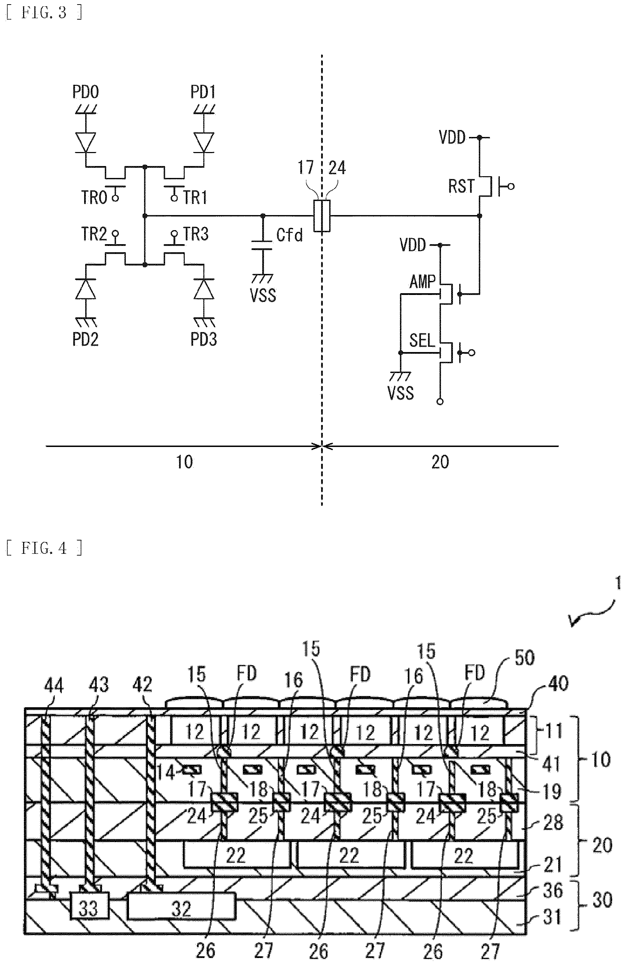

FIG. 3 illustrates an example of the sensor pixels 12 and the readout circuit 22. Hereinafter, a description is given of, for example, a case where four sensor pixels 12 disposed in two rows × two columns share one readout circuit 22, as illustrated in FIG. 3. Here, the term "sharing" indicates that outputs of the plurality of sensor pixels 12 are inputted into the common readout circuit 22.

The respective sensor pixels 12 include components common to each other. In FIG. 3, identification numbers (1, 2, 3, and 4) are assigned to endings of reference signs of the components of the respective sensor pixels 12 to distinguish the components of the respective sensor pixels 12 from each other. Hereinafter, in a case where the components of the respective sensor pixels 12 are to be distinguished from each other, the identification numbers are assigned to the endings of the reference signs of the components of the respective sensor pixels 12. However, in a case where the components of the respective sensor pixels 12 are not to be distinguished from each other, the identification numbers assigned to the endings of the reference signs of the components of the respective sensor pixels 12 are omitted.

Each of the sensor pixels 12 includes, for example, a photodiode PD, a transfer transistor TR electrically coupled to the photodiode PD, and a floating diffusion FD that temporarily holds electric charge outputted from the photodiode PD through the transfer transistor TR. For example, one floating diffusion FD is provided for the plurality of sensor pixels 12 sharing the readout circuit 22. It is to be noted that one floating diffusion FD may be provided for one sensor pixel 12. In this case, wiring lines that electrically couple the respective floating diffusions FD to each other are provided in the plurality of sensor pixels 12 sharing the readout circuit 22.

The photodiode PD generates electric charge corresponding to the amount of received light by performing photoelectric conversion. A cathode of the photodiode PD is electrically coupled to a source of the transfer transistor TR. An anode of the photodiode PD is electrically coupled to a region (a p-well region 41 described later) having a reference potential VSS in the semiconductor substrate 11. A drain of the transfer transistor TR is electrically coupled to the floating diffusion FD. A gate of the transfer transistor TR is electrically coupled to the logic circuit 32 through the drive wiring line 14 and a through-wiring line 42 described later. The transfer transistor TR is, for example, a CMOS (Complementary Metal Oxide Semiconductor) transistor.

The floating diffusion FD is a floating diffusion region that temporarily holds the electric charge outputted from the photodiode PD through the transfer transistor TR. An input end of the readout circuit 22 is coupled to the floating diffusion FD. Specifically, a reset transistor RST described later is coupled to the floating diffusion FD, and the vertical signal line VSL is further coupled to the floating diffusion FD through an amplification transistor AMP described later and a selection transistor SEL described later. The floating diffusion FD generates capacitance Cfd. For example, the capacitance Cfd is generated between the region (e.g., the p-well region 41) having the reference potential VSS in the first substrate 10 and a wiring line that couples each of the sensor pixels 12 and an FD junction electrode 17, as illustrated in FIG. 3.

The readout circuit 22 includes, for example, the reset transistor RST, the selection transistor SEL, and the amplification transistor AMP. It is to be noted that the selection transistor SEL may be omitted as necessary. A source of the reset transistor RST (the input end of the readout circuit 22) is electrically coupled to the floating diffusion FD. A drain of the reset transistor RST is electrically coupled to a wiring line to which the power supply potential VDD is to be applied through a through-wiring line 43 described later, and to a drain of the amplification transistor AMP. A gate of the reset transistor RST is electrically coupled to the logic circuit 32 through the through-wiring line 42. A source of the amplification transistor AMP is electrically coupled to a drain of the selection transistor SEL. A gate of the amplification transistor AMP is electrically coupled to the source of the reset transistor RST. A source of the selection transistor SEL (an output end of the readout circuit 22) is electrically coupled to the logic circuit 32 through the vertical signal line VSL and the through-wiring line 42. A gate of the selection transistor SEL is electrically coupled to the logic circuit 32 through the through-wiring line 42.

When the transfer transistor TR is brought into an on state, the transfer transistor TR transfers the electric charge of the photodiode PD to the floating diffusion FD. The reset transistor RST resets a potential of the floating diffusion FD to a predetermined potential. When being brought into the on state, the reset transistor RST resets the potential of the floating diffusion FD to the power supply potential VDD. The selection transistor SEL controls an output timing of the pixel signal from the readout circuit 22. The amplification transistor AMP generates, as the pixel signal, a signal of a voltage corresponding to a level of the electric charge held in the floating diffusion FD. The amplification transistor AMP configures a source follower amplifier, and outputs a pixel signal of the voltage corresponding to the level of the electric charge generated in the photodiode PD. When the selection transistor SEL is brought into the on state, the amplification transistor AMP amplifies the potential of the floating diffusion FD to output a voltage corresponding to the potential to the logic circuit 32 through the vertical signal line VSL. The reset transistor RST, the amplification transistor AMP, and the selection transistor SEL are, for example, CMOS transistors.

It is to be noted that the selection transistor SEL may be provided between the power supply line VDD and the amplification transistor AMP. In this case, the drain of the reset transistor RST is electrically coupled to the wiring line to which the power supply potential VDD is to be applied, and to the drain of the selection transistor SEL. The source of the selection transistor SEL is electrically coupled to the drain of the amplification transistor AMP. The gate of the selection transistor SEL is electrically coupled to the logic circuit 32 through the through-wiring line 42. The source of the amplification transistor AMP (the output end of the readout circuit 22) is electrically coupled to the logic circuit 32 through the vertical signal line VSL and the through-wiring line 42. The gate of the amplification transistor AMP is electrically coupled to the source of the reset transistor RST.

FIG. 4 illustrates an example of a cross-sectional configuration in a vertical direction of the imaging device 1. FIG. 4 illustrates, as examples, a cross-sectional configuration of a location opposed to the pixel region 13 (the sensor pixels 12) and a cross-sectional configuration of a region surrounding the pixel region 13 in the imaging device 1. The imaging device 1 is configured as a stack in which the first substrate 10, the second substrate 20, and the third substrate 30 are stacked in this order, and further includes a color filter layer 40 and a light-receiving lens 50 on a side of a back surface (a side of a light incident surface) of the first substrate 10. The color filter layer 40 and the light-receiving lens 50 are each provided, for example, one by one for each of the sensor pixels 12. That is, the imaging device 1 is a back side illumination imaging device.

The first substrate 10 is configured as a stack in which an insulating layer 19 is stacked on the semiconductor substrate 11. The first substrate 10 includes the insulating layer 19 as an interlayer insulating film. The insulating layer 19 is provided between the semiconductor substrate 11 and the second substrate 20. The insulating layer 19 corresponds to a specific example of a "first interlayer insulating film" of the present disclosure. The first substrate 10 includes the plurality of drive wiring lines 14 in the insulating layer 19. The plurality of drive wiring lines 14 is provided one by one for each of the rows in the plurality of sensor pixels 12 disposed in a matrix pattern. The semiconductor substrate 11 includes a silicon substrate. The semiconductor substrate 11 includes, for example, the p-well region 41 on a portion of a front surface thereof and in the vicinity of such a portion, and includes the photodiode PD of an electrically-conductive type different from the p-well region 41 in a region other than the p-well region 41 (a region deeper than the p-well region 41). The p-well region 41 includes a p-type semiconductor region. The photodiode PD includes a semiconductor region of an electrically-conductive type (specifically, an n-type) different from the p-well region 41. The semiconductor substrate 11 includes in the p-well region 41 the floating diffusions FD as a semiconductor region of an electrically-conductive type (specifically, the n-type) different from the p-well region 41.

The first substrate 10 includes the photodiode PD and the transfer transistor TR for each of the sensor pixels 12, and includes the floating diffusion FD for every one or more of the sensor pixels 12. The first substrate 10 is configured in such a manner that the transfer transistor TR and the floating diffusion FD are provided at a portion on the side of the front surface of the semiconductor substrate 11 (an opposite side to the side of the light incident surface, i.e., a side of the second substrate 20). The first substrate 10 includes an element separator that separates each of the sensor pixels 12. The element separator is formed to extend in a normal direction of the semiconductor substrate 11 (in a direction perpendicular to the front surface of the semiconductor substrate 11). The element separator is provided between two sensor pixels 12 adjacent to each other. The element separator electrically separates the two sensor pixels 12 adjacent to each other. The element separator includes, for example, silicon oxide. The first substrate 10 further includes, for example, a fixed charge film in contact with a back surface of the semiconductor substrate 11. The fixed charge film is negatively charged to suppress generation of a dark current caused by an interface state of a side of a light-receiving surface of the semiconductor substrate 11. The fixed charge film is formed by, for example, an insulating film having negative fixed charge. Examples of a material of such an insulating film include hafnium oxide, zirconium oxide, aluminum oxide, titanium oxide, and tantalum oxide. A hole accumulation layer is provided at an interface on the side of the light-receiving surface of the semiconductor substrate 11 by an electric field induced by the fixed charge film. The hole accumulation layer suppresses generation of electrons from the interface. The color filter layer 40 is provided on the side of the back surface of the semiconductor substrate 11. The color filter layer 40 is provided, for example, in contact with the fixed charge film, and is provided at a position opposed to the sensor pixel 12 with the fixed charge film interposed therebetween. The light-receiving lens 50 is provided, for example, in contact with the color filter layer 40, and is provided at a position opposed to the sensor pixel 12 with the color filter layer 40 and the fixed charge film interposed therebetween.

The first substrate 10 includes, in the insulating layer 19, a plurality of FD through-wiring lines 15 and a plurality of VSS through-wiring lines 16. The plurality of FD through-wiring lines 15 and the plurality of VSS through-wiring lines penetrate the insulating layer 19. Each of the VSS through-wiring lines 16 is disposed in a gap between two FD through-wiring lines 15 adjacent to each other among the plurality of FD through-wiring lines 15. The first substrate 10 further includes, in the insulating layer 19, a plurality of FD junction electrodes 17 and a plurality of VSS junction electrodes 18. The plurality of FD junction electrodes 17 and the plurality of VSS junction electrodes 18 are both exposed on a surface of the insulating layer 19. The FD junction electrode 17 corresponds to a specific example of a "first junction electrode" of the present disclosure. The VSS junction electrode 18 corresponds to a specific example of a "first shield electrode" of the present disclosure. The plurality of FD through-wiring lines 15 and the plurality of VSS through-wiring lines 16 are provided in a region opposed to the pixel region 13. For example, each of the VSS junction electrodes 18 is formed in the same plane as each of the FD junction electrodes 17. The VSS junction electrode 18 is disposed in a gap between two FD junction electrodes 17 adjacent to each other among the plurality of FD junction electrodes 17.

In a case where one floating diffusion FD is provided for the plurality of sensor pixels 12 sharing the readout circuit 22, the plurality of FD through-wiring lines 15 is provided one by one for every plurality of sensor pixels 12 sharing the readout circuit 22. In a case where one floating diffusion FD is provided for one sensor pixel 12, the plurality of FD through-wiring lines 15 is provided one by one for each of the sensor pixels 12.

Each of the FD through-wiring lines 15 is coupled to the floating diffusion FD and the FD junction electrode 17. In a case where one floating diffusion FD is provided for the plurality of sensor pixels 12 sharing the readout circuit 22, the plurality of VSS through-wiring lines 16 is provided one by one for every plurality of sensor pixels 12 sharing the readout circuit 22. In a case where one floating diffusion FD is provided for one sensor pixel 12, the plurality of VSS through-wiring lines 16 is provided one by one for each of the sensor pixels 12. Each of the VSS through-wiring lines 16 is coupled to the p-well region 41 and the VSS junction electrode 18. In either case, the plurality of VSS through-wiring lines 16 is provided one by one for each of the readout circuits 22.

The second substrate 20 is configured as a stack in which an insulating layer 28 is stacked on the semiconductor substrate 21. The second substrate 20 includes the insulating layer 28 as an interlayer insulating film. The insulating layer 28 is provided between the semiconductor substrate 21 and the first substrate 10. The insulating layer 28 corresponds to a specific example of a "second interlayer insulating film" of the present disclosure. The semiconductor substrate 21 includes a silicon substrate. The second substrate 20 includes one readout circuit 22 for every four sensor pixels 12. The second substrate 20 is configured in such a manner that the readout circuit 22 is provided at a portion on a side of a front surface of the semiconductor substrate 21. The second substrate 20 is bonded to the first substrate 10 with the front surface of the semiconductor substrate 21 directed toward the side of the front surface of the semiconductor substrate 11.

The second substrate 20 includes, in the insulating layer 28, a plurality of FD through-wiring lines 26 and a plurality of VSS through-wiring lines 27. The plurality of FD through-wiring lines 26 and the plurality of VSS through-wiring lines 27 penetrate the insulating layer 28. Each of the VSS through-wiring lines 27 is disposed in a gap between two FD through-wiring lines 26 adjacent to each other among the plurality of FD through-wiring lines 26. The second substrate 20 further includes, in the insulating layer 28, a plurality of FD junction electrodes 24 and a plurality of VSS junction electrodes 25. The plurality of FD junction electrodes 24 and the plurality of VSS junction electrodes 25 are both exposed on a surface of the insulating layer 28. The FD junction electrode 24 corresponds to a specific example of a "second junction electrode" of the present disclosure. The VSS junction electrode 25 corresponds to a specific example of a "second shield electrode" of the present disclosure. The plurality of FD junction electrodes 24 is provided one by one for each of the FD junction electrodes 17 of the first substrate 10. The FD junction electrode 24 is electrically coupled to the FD junction electrode 17. Each of the VSS junction electrodes 25 is, for example, formed in the same plane as each of the FD junction electrodes 24. The VSS junction electrode 25 is disposed in a gap between two FD junction electrodes 24 adjacent to each other among the plurality of FD junction electrodes 24. The sensor pixel 12 and the readout circuit 22 are electrically coupled to each other through junction between the FD junction electrodes 17 and 24.

The plurality of FD junction electrodes 24 and the plurality of FD through-wiring lines 26 are provided in the region opposed to the pixel region 13. The plurality of FD through-wiring lines 26 is provided one by one for each of the FD through-wiring lines 15. Each of the FD through-wiring lines 26 is coupled to the FD junction electrode 24 and the readout circuit 22 (specifically, the gate of the amplification transistor AMP). The plurality of VSS junction electrodes 25 and the plurality of VSS through-wiring lines 27 are provided in the region opposed to the pixel region 13. The plurality of VSS through-wiring lines 27 is provided one by one for each of the VSS through-wiring lines 16. Each of the VSS through-wiring lines 27 is coupled to the VSS junction electrode 25 and a region to which the reference potential VSS is to be applied in the second substrate 20 (a reference potential region of the readout circuit 22).

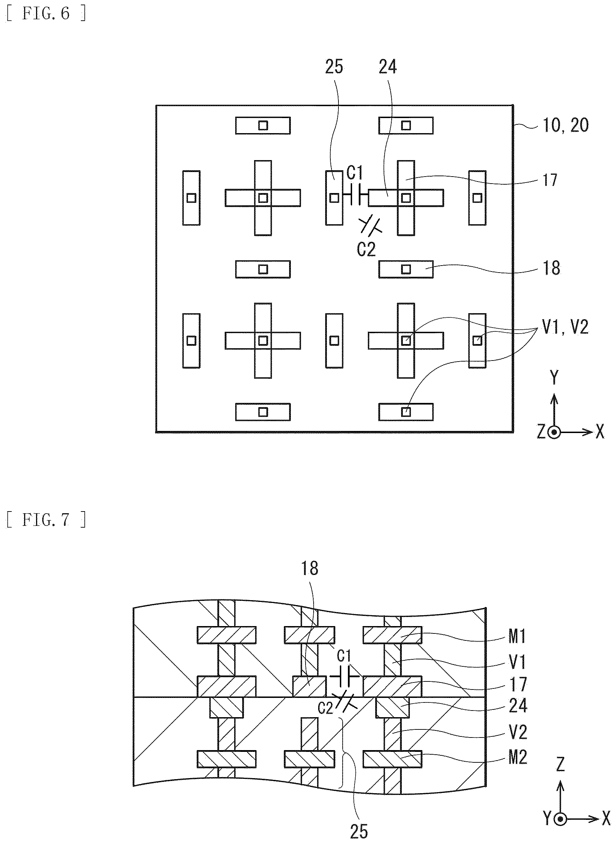

The plurality of FD junction electrodes 17 and the plurality of FD junction electrodes 24 include, for example, copper. The plurality of FD junction electrodes 17 and the plurality of FD junction electrodes 24 are disposed to be opposed to each other, and are joined to each other. The plurality of VSS junction electrodes 18 and the plurality of VSS junction electrodes 25 include, for example, copper. Although described in detail later, for example, each of the VSS junction electrodes 18 and each of the VSS junction electrodes 25 are selectively provided respectively between the FD junction electrodes 17 adjacent to each other, for example, in the column direction (a Y-axis direction), and between the FD junction electrodes 24 adjacent to each other, for example, in the row direction (an X-axis direction). This allows each of the plurality of VSS junction electrodes 18 and each of the plurality of VSS junction electrodes 25 not to be joined to each other (for example, see FIG. 7).

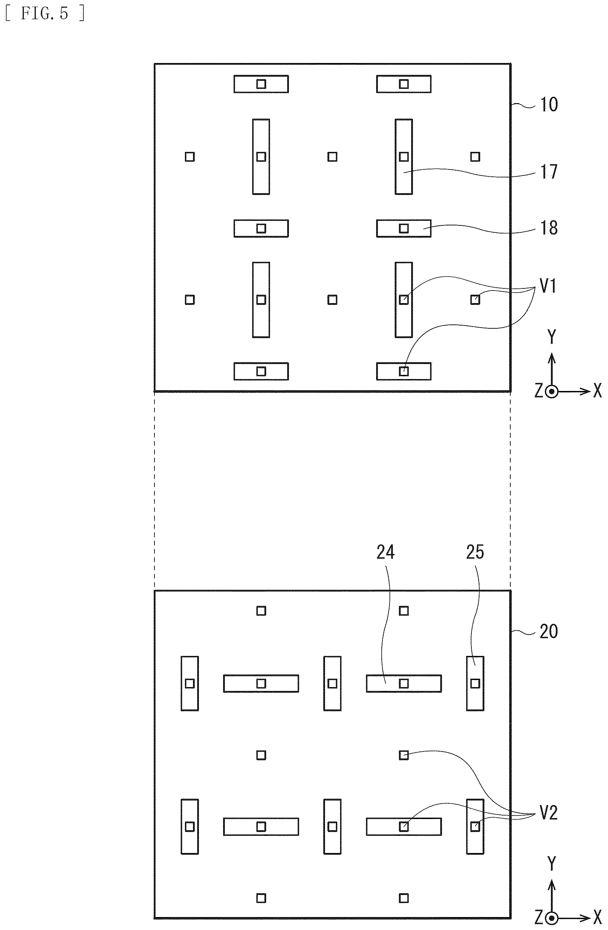

FIG. 5 illustrates an example of a cross-sectional configuration in a horizontal direction of the first substrate 10 and the second substrate 20 in the present embodiment.

The plurality of FD junction electrodes 17 and the plurality of FD junction electrodes 24 each have a planar shape having a longitudinal direction in a corresponding one of directions substantially orthogonal to each other (e.g., the X-axis direction or the Y-axis direction). For example, the plurality of FD junction electrodes 17 provided on a junction surface of the first substrate 10 with the second substrate 20 has a substantially rectangular shape having long sides in the Y-axis direction, as illustrated in FIG. 5. The plurality of FD junction electrodes 24 provided on a junction surface of the second substrate 20 with the first substrate 10 has a substantially rectangular shape having long sides in the X-axis direction, as illustrated in FIG. 5. This allows, when the first substrate 10 and the second substrate 20 are bonded to each other, each of the FD junction electrodes 17 and a corresponding one of the FD junction electrodes 24 to be coupled to be substantially orthogonal to each other, as illustrated in FIG. 6.

One of the VSS junction electrode 18 or the VSS junction electrode 25 and another one of the VSS junction electrode 18 or the VSS junction electrode 25 are selectively provided respectively between the FD junction electrodes adjacent to each other, for example, in the column direction, and between the FD junction electrodes adjacent to each other, for example, in the row direction. This allows the plurality of VSS junction electrodes 18 and the plurality of VSS junction electrodes 25 not to be joined to each other on the junction surfaces, as illustrated in FIG. 7. For example, the plurality of VSS junction electrodes 18 provided on the junction surface of the first substrate 10 with the second substrate 20 is each provided only between the FD junction electrodes 17 adjacent to each other in the Y-axis direction, as illustrated in FIG. 5. The plurality of VSS junction electrodes 25 provided on the junction surface of the second substrate 20 with the first substrate 10 is each provided only between the FD junction electrodes 24 adjacent to each other in the X-axis direction, as illustrated in FIG. 5.

It is to be noted that the plurality of FD through-wiring lines 15 coupled to the plurality of FD junction electrodes 17 and the plurality of VSS through-wiring lines 16 coupled to the plurality of VSS junction electrodes 18 include, for example, a via V1 and a metal layer M1, as illustrated in FIG. 7. The plurality of FD through-wiring lines 26 coupled to the plurality of FD junction electrodes 24 and the plurality of VSS through-wiring lines 27 coupled to the plurality of VSS junction electrodes 25 include, for example, a via V2 and a metal layer M2, as illustrated in FIG. 7. As described above, the VSS junction electrodes 18 are each provided in contact with the via V1 between the FD junction electrodes 17 adjacent to each other in the Y-axis direction on the junction surface of the first substrate 10 with the second substrate 20; however, each portion up to the via V1 is formed between the FD junction electrodes 17 adjacent to each other in the X-axis direction, with the VSS junction electrode 18 being omitted. Further, the VSS junction electrodes 25 are each provided in contact with the via V2 between the FD junction electrodes 24 adjacent to each other in the X-axis direction on the junction surface of the second substrate 20 with the first substrate 10; however, each portion up to the via V2 is formed between the FD junction electrodes 24 adjacent to each other in the Y-axis direction, with the VSS junction electrode 25 being omitted.

The plurality of VSS junction electrodes 18 and the plurality of VSS junction electrodes 25 each have a planar shape having a longitudinal direction in a corresponding one of the directions substantially orthogonal to each other (e.g., the X-axis direction or the Y-axis direction), in a similar manner to the plurality of FD junction electrodes 17 and the plurality of FD junction electrodes 24. For example, the plurality of VSS junction electrodes 18 has a substantially rectangular shape having long sides in the X-axis direction, and the long side of the VSS junction electrode 18 is opposed to a short side of the closest FD junction electrode 17. For example, the plurality of VSS junction electrodes 25 has a substantially rectangular shape having long sides in the Y-axis direction, and the long side of the VSS junction electrode 25 is opposed to a short side of the closest FD junction electrode 24.

A length of the long sides of each of the plurality of VSS junction electrodes 18 and the plurality of VSS junction electrodes 25 is shorter than a length of the long sides of each of the plurality of FD junction electrodes 17 and the plurality of FD junction electrodes 24. In addition, a width of the plurality of VSS through-wiring lines 16 and the plurality of VSS through-wiring lines 27 is equal to or narrower than a width of the plurality of VSS through-wiring lines 16 and the plurality of FD through-wiring lines 26.

Such a configuration reduces inter-electrode capacitance C1, as compared with a case where the plurality of FD junction electrodes 17, the plurality of FD junction electrodes 24, the plurality of VSS junction electrodes 18, and the plurality of VSS junction electrodes 25 are each square or circular. The inter-electrode capacitance C1 is generated between the FD junction electrode 17 and the VSS junction electrode 18 closest to each other or between the FD junction electrode 24 and the VSS junction electrode 25 closest to each other in respective ones of the first substrate 10 and the second substrate 20. Further, inter-electrode capacitance C2 similarly reduces, as compared with a case where the plurality of FD junction electrodes 17, the plurality of FD junction electrodes 24, the plurality of VSS junction electrodes 18, and the plurality of VSS junction electrodes 25 are each square or circular. The inter-electrode capacitance C2 is generated between the FD junction electrode 17 and the VSS junction electrode 25 closest to each other or between the FD junction electrode 24 and the VSS junction electrode 18 closest to each other when the first substrate 10 and the second substrate 20 are bonded to each other.

It is to be noted that in a case where the VSS junction electrode 18 or the VSS junction electrode 25 is exposed on the junction surface of a corresponding one of the first substrate 10 and the second substrate 20 in the present embodiment, the junction surface opposed to the corresponding junction electrode is not provided with the VSS junction electrode 25 or the VSS junction electrode 18. In this case, the VSS through-wiring line 16 and the VSS through-wiring line 27 function as shield electrodes between the adjacent FD junction electrodes 17 and between the adjacent FD junction electrodes 24, respectively. Moreover, for example, GND, in addition to VSS, may be applied as a reference potential to each of the VSS junction electrode 18 and the VSS junction electrode 25.

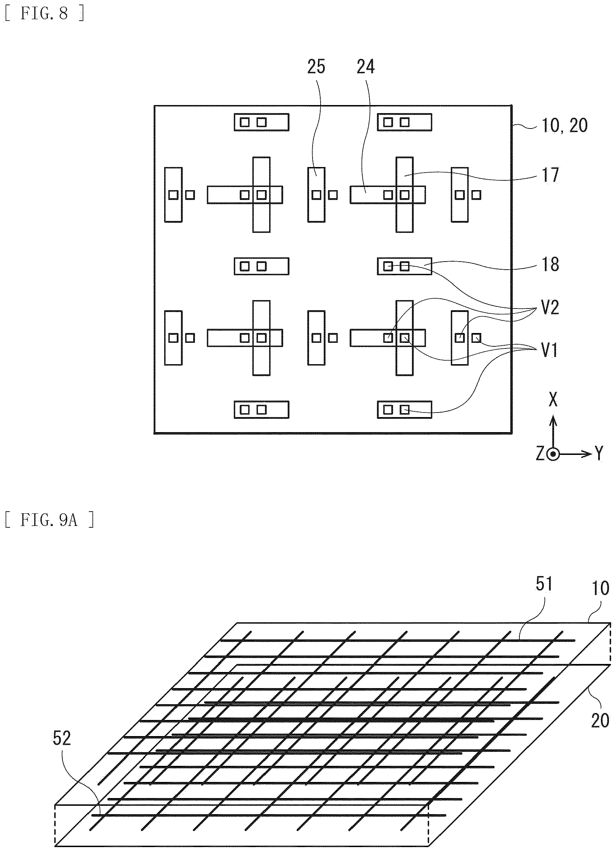

FIG. 8 illustrates a mode in a case where misalignment occurs in bonding the first substrate 10 and the second substrate 20 to each other. In the present embodiment, the plurality of FD junction electrodes 17 and the plurality of FD junction electrodes 24 each have a planar shape having a longitudinal direction in a corresponding one of the directions substantially orthogonal to each other, as described above. This enables each of the FD junction electrodes 17 and each of the FD junction electrodes 24, which correspond to each other, to be coupled to each other even if the misalignment occurs.

In addition, shield electrodes (the VSS junction electrodes 18 or the VSS junction electrodes 25) each provided between the FD junction electrodes 17 closest and adjacent to each other or between the respective FD junction electrodes 24 closest and adjacent to each other are provided in the respective same substrates, and thus are not influenced by the misalignment. Further, the shield electrodes each provided on a side of the different substrate between the FD junction electrodes 17 closest and adjacent to each other or between the respective FD junction electrodes 24 closest and adjacent to each other are at distant positions therefrom, as compared with a case where the plurality of FD junction electrodes 17, the plurality of FD junction electrodes 24, the plurality of VSS junction electrodes 18, and the plurality of VSS junction electrodes 25 are each square or circular. This allows the FD junction electrodes and the VSS junction electrodes not to come into contact with each other even if the misalignment occurs.

Furthermore, in the present embodiment, the plurality of VSS junction electrodes 18 and the plurality of VSS junction electrodes 25 are each provided only on a side of one of the substrates not to be joined to each other. The plurality of VSS junction electrodes 18 and the plurality of VSS junction electrodes 25 each provided on the side of the different substrate between the adjacent FD junction electrodes 17 or between the respective adjacent FD junction electrodes 24 are remote therefrom, as compared with a case where the plurality of FD junction electrodes 17, the plurality of FD junction electrodes 24, the plurality of VSS junction electrodes 18, and the plurality of VSS junction electrodes 25 are each square or circular. This allows the FD junction electrodes each provided on a side of one of the substrates and the VSS junction electrodes each provided on a side of another one of the substrates not to come into contact with each other. This helps to shorten a coupling pitch.

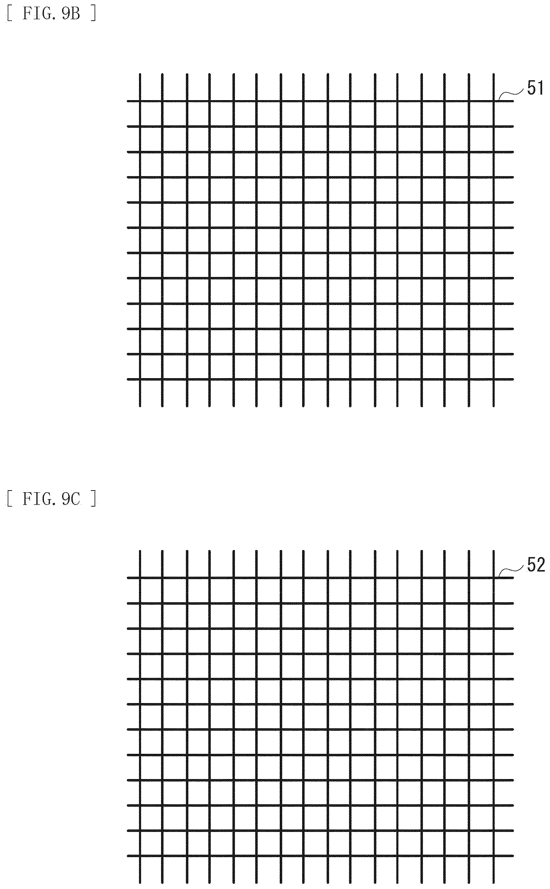

FIG. 9A is a schematic diagram illustrating a layout of reference potential application wiring lines 51 and 52 in the first substrate 10 and the second substrate 20. FIGs. 9B and 9C schematically illustrate planar layouts of the reference potential application wiring lines 51 and 52 provided in the first substrate 10 and the second substrate 20, respectively. The reference potential application wiring lines 51 and 52 may be each provided in a net pattern in which a plurality of wire lines extending in the row direction and the column direction intersect each other, for example. It is to be noted that the plurality of wiring lines extending in the row direction and the column direction may not necessarily be provided in the same wiring layer, and may be provided across a plurality of layers. Further, for example, in a case of driving to read the rows in sequence, such a layout may be provided that, for example, the reference potential application wiring lines 51 and 52 extend side by side only in the column direction.

A stack including the first substrate 10 and the second substrate 20 includes, in the region surrounding the pixel region 13, a plurality of through-wiring lines 42 penetrating the first substrate 10 and the second substrate 20. The plurality of through-wiring lines 42 is provided one by one for each of the drive wiring lines 14 of the first substrate 10. Each of the through-wiring lines 42 is coupled to the drive wiring line 14 and the vertical drive circuit 32a of the logic circuit 32. Therefore, the logic circuit 32 controls the sensor pixels 12 and the readout circuits 22 through the plurality of through-wiring lines 42. Each of the through-wiring lines 42 includes, for example, a TSV (Through Silicon Via). It is to be noted that, in place of each of the through-wiring lines 42, a through-wiring line penetrating the insulating layer 19 (hereinafter, referred to as a "through-wiring line a"), a through-wiring line penetrating the insulating layer 28 (hereinafter, referred to as a "through-wiring line b"), a junction electrode coupled to the through-wiring line a (hereinafter, referred to as a "junction electrode c"), and a junction electrode coupled to the through-wiring line b (hereinafter, referred to as a "junction electrode d") may be provided. At this time, the junction electrodes c and d include, for example, copper, and the junction electrode c and the junction electrode d are joined to each other.

The stack including the first substrate 10 and the second substrate 20 further includes, around the pixel region 13, the through-wiring line 43 and a through-wiring line 44, each of which penetrates the first substrate 10 and the second substrate 20. The through-wiring lines 43 and 44 include, for example, the TSV. The through-wiring line 43 is coupled to the booster circuit 33 of the third substrate 30 and has the power supply potential VDD. The power supply potential VDD is a value within a range of 2.5 V to 2.8 V, for example. The through-wiring line 44 is electrically coupled to a region to which the reference potential VSS is to be applied in the third substrate 30 (a reference potential region of the third substrate 30) and has the reference potential VSS. The reference potential VSS is, for example, zero volts.

The third substrate 30 is, for example, configured as a stack in which an insulating layer 36 is stacked on the semiconductor substrate 31. The third substrate 30 includes the insulating layer 36 as an interlayer insulating film. The insulating layer 36 is provided between the semiconductor substrate 31 and the second substrate 20. The semiconductor substrate 31 includes a silicon substrate. The third substrate 30 is configured in such a manner that the logic circuit 32 is provided at a portion on a side of a front surface of the semiconductor substrate 31 (the side of the second substrate 20). The third substrate 30 is bonded to the second substrate 20 with the front surface of the semiconductor substrate 31 directed toward a side of a back surface of the semiconductor substrate 21.

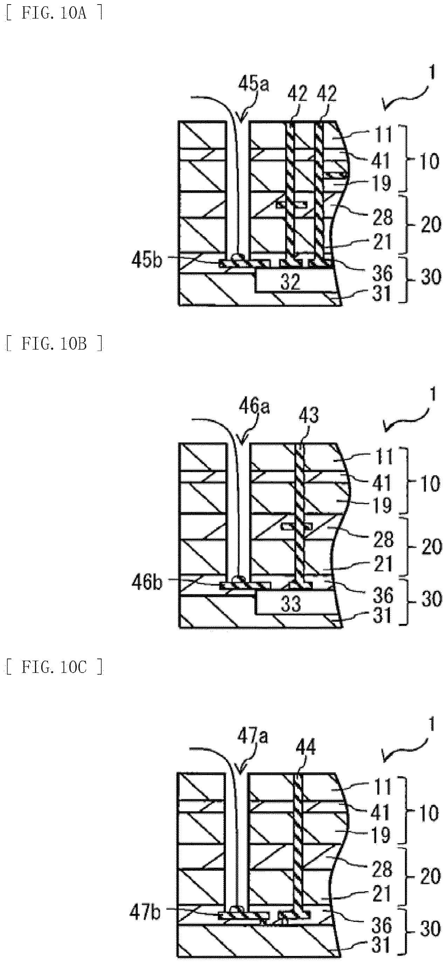

FIG. 10A illustrates an example of a wiring structure adapted to take out the output voltage Vout outputted from the logic circuit 32 from the imaging device 1. FIG. 10B illustrates an example of a wiring structure adapted to supply the reference potential to the booster circuit 33. FIG. 10C illustrates an example of a wiring structure adapted to supply the reference potential VSS to the third substrate 30. The stack including the first substrate 10 and the second substrate 20 includes, around the pixel region 13, openings 45a, 46a, and 47a, each of which penetrates the first substrate 10 and the second substrate 20. A coupling pad 45b is provided on a bottom surface of the opening 45a, and the coupling pad 45b is coupled to an output end of the logic circuit 32. For example, a bonding wire is coupled to the coupling pad 45b. A coupling pad 46b is provided on a bottom surface of the opening 46a, and the coupling pad 46b is coupled to the booster circuit 33. For example, a bonding wire is coupled to the coupling pad 46b. A coupling pad 47b is provided on a bottom surface of the opening 47a, and the coupling pad 47b is coupled to a region for which the reference potential VSS is to be applied in the third substrate 30. For example, a bonding wire is coupled to the coupling pad 47b.

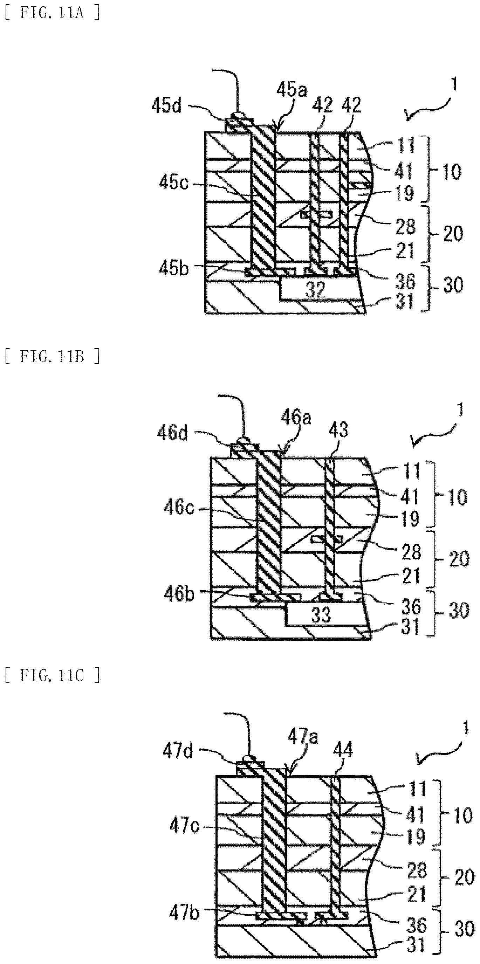

It is to be noted that a through-wiring line 45c may be provided inside the opening 45a, as illustrated in FIG. 11A. In this case, for example, a coupling pad 45d may be provided on a front surface of the first substrate 10 corresponding to the through-wiring line 45c, and a bonding wire may be coupled to the coupling pad 45d. Further, a through-wiring line 46c may be provided inside the opening 46a, as illustrated in FIG. 11B. In this case, for example, a coupling pad 46d may be provided on the front surface of the first substrate 10 corresponding to the through-wiring line 46c, and a bonding wire may be coupled to the coupling pad 46d. In addition, a through-wiring line 47c may be provided inside the opening 47a, as illustrated in FIG. 11C. In this case, for example, a coupling pad 47d may be provided on the front surface of the first substrate 10 corresponding to the through-wiring line 47c, and a bonding wire may be coupled to the coupling pad 47d.

### [Workings and Effects]

In the imaging device 1 of the present embodiment, the junction surface of the first substrate 10 with the second substrate 20 and the junction surface of the second substrate 20 with the first substrate 10 are respectively provided with the plurality of FD junction electrodes 17 having a substantially rectangular shape having long sides, for example, in the Y-axis direction, and the plurality of FD junction electrodes 24 having a substantially rectangular shape having long sides, for example, in the X-axis direction. This increases a distance between the adjacent FD junction electrodes 17 or 24 to reduce capacitance between the adjacent FD junction electrodes 17 or 24. A description is given below of this point.

Miniaturization of an area per pixel in the imaging device of a two-dimensional structure has been achieved through adoption of miniaturization processes and improvement in mounting density. In recent years, an imaging device of a three-dimensional structure has been developed to achieve a more compact imaging device and higher density of pixels. The imaging device of a three-dimensional structure includes, for example, pixel light-receiving elements provided in a two-dimensional array in one (e.g., a first semiconductor substrate) of two stacked semiconductor substrates (the first semiconductor substrate and a second semiconductor substrate), and pixel circuit elements provided in a two-dimensional array in another one (e.g., the second semiconductor substrate) of the two stacked semiconductor substrates. The pixel light-receiving elements each include a photodiode serving as a light receiver, a floating diffusion layer, and a portion of a readout circuit adapted to read a voltage signal of the floating diffusion layer, and the pixel circuit elements are each disposed with a portion of the readout circuit adapted to read the voltage signal of the floating diffusion layer. The two stacked semiconductor substrates are electrically coupled to each other by bringing respective metal wiring lines into contact with each other.

The first semiconductor substrate and the second semiconductor substrate allow a signal to be transmitted from the first semiconductor substrate to the second semiconductor substrate by coupling a wiring terminal (e.g., an output of the readout circuit or the floating diffusion layer) of a signal generated in the first semiconductor substrate to a coupling terminal of the second semiconductor substrate.

Further, to prevent signal interference between the signal terminals of adjacent pixels, shield wiring lines adapted to prevent interference are disposed between the signal terminals, and the first semiconductor substrate and the second semiconductor substrate are electrically coupled to each other by bringing the shield wiring lines into contact with each other between the first semiconductor substrate and the second semiconductor substrate. For example, the reference potential (GND or VSS) is applied to the shield wiring lines.

In the imaging device of such a three-dimensional structure, the readout circuit is formed in the first semiconductor substrate and the second semiconductor substrate, which makes it possible to increase an element size of a MOS-FET (e.g., an AMO transistor serving as a signal output element) constituting the readout circuit while expanding an area of the light receiver. This allows for reduction in noise generated therein. Therefore, it is possible to obtain a high-quality image having less noise and a wide dynamic range on a reproduced screen.

Incidentally, in a typical imaging device of a three-dimensional structure, wiring lines adapted to apply the reference potential extend in the row direction and the column direction to cause the reference potential to be uniformly applied in a pixel array, and the wiring lines extending in the row direction and the column direction are disposed to intersect each other to be integrated in a mesh pattern. Specifically, for example, metal wiring lines to which the reference potential is to be applied extend in the column direction on a semiconductor substrate in which a readout circuit is disposed, and metal wiring lines to which the reference potential is to be applied extend in the row direction on a semiconductor substrate including a light receiver. Further, the metal wiring lines adapted to apply the reference potential on the two semiconductor substrates are electrically coupled to each other through coupling pads that couple the two semiconductor substrates to each other. This allows the metal wiring lines adapted to apply the reference potential to be coupled to each other in a mesh pattern in a matrix/two-dimensional direction.

In the above-described technique, the shield wiring lines are disposed between the signal terminals of at least four pixels, per signal terminal, adjacent to each other in the matrix direction, and junction surfaces of the respective semiconductor substrates are provided with the coupling pads coupled to respective ones of the signal terminals and the shield wiring lines. As a result, the two semiconductor substrates are electrically coupled to each other. However, an imaging device for which a high-resolution image is demanded involves a large number of pixels and a small pixel size, thus resulting in less room in which the coupling pads of the shield wiring lines are disposed between the coupling pads of the signal terminals.

In particular, as for an amount of misalignment in coupling the two semiconductor substrates in a coupling step, a pitch between the coupling pads and the amount of misalignment are closer to each other in the imaging device with a reduced pixel size, because the joining step is a joining step of wafers of wafer bodies. This makes it difficult to dispose the coupling pads of the shield wiring lines between the coupling pads of the signal terminals. For example, large misalignment in disposing the coupling pads of the shield wiring lines between the coupling pads of the signal terminals causes the coupling pads of the signal terminals and the coupling pads of the shield wiring lines to come into contact with each other. This results in an issue that signals are unable to be transmitted between the two semiconductor substrates to cause a significant image failure on an image being reproduced.

In contrast, in the present embodiment, the plurality of FD junction electrodes 17 and the plurality of FD junction electrodes 24 each having a substantially rectangular shape having long sides in a corresponding one of the directions substantially orthogonal to each other (e.g., the X-axis direction or the Y-axis direction) are provided on the respective junction surfaces of the first substrate 10 and the second substrate 20. This makes it possible to increase the distance between the adjacent FD junction electrodes 17 or 24 to reduce the capacitance between the adjacent FD junction electrodes 17 or 24.

As described above, in the imaging device 1 of the present embodiment, the signal interference between the respective adjacent FD junction electrodes 17 or 24 is suppressed. This makes it possible to provide an imaging device with a high image quality.

Further, in the imaging device 1 of the present embodiment, for example, one of the VSS junction electrode 18 or the VSS junction electrode 25 and another one of the VSS junction electrode 18 or the VSS junction electrode 25 are selectively provided respectively between the FD junction electrodes adjacent to each other in the column direction and between the FD junction electrodes adjacent to each other in the row direction. This allows the plurality of VSS junction electrodes 18 and the plurality of VSS junction electrodes 25 each provided between the adjacent FD junction electrodes 17 or between the adjacent FD junction electrodes 24 not to be joined to each other on the respective junction surfaces. Furthermore, the plurality of VSS junction electrodes 18 and the plurality of VSS junction electrodes 25 each have a substantially rectangular shape having long sides in a corresponding one of the directions substantially orthogonal to each other, in a similar manner to the plurality of FD junction electrodes 17 and the plurality of FD junction electrodes 24. The long side of the VSS junction electrode 18 is opposed to the short side of the closest FD junction electrode 17, and the long side of the VSS junction electrode 25 is opposed to the short side of the closest FD junction electrode 24.

This makes it possible to reduce inter-electrode capacitance between the FD junction electrode 17 and the VSS junction electrode 18 closest to each other or between the FD junction electrode 24 and the VSS junction electrode 25 closest to each other in the respective ones of the first substrate 10 and the second substrate 20. In addition, it is possible to reduce inter-electrode capacitance between the FD junction electrode 17 and the VSS junction electrode 25 closest to each other or between the FD junction electrode 24 and the VSS junction electrode 18 closest to each other when the first substrate 10 and the second substrate 20 are bonded to each other. Therefore, it is possible to further suppress the signal interference between the respective adjacent FD junction electrodes 17 or 24 to further enhance an image quality.

Furthermore, the above-described configuration of the imaging device 1 of the present embodiment allows a risk of electrical conduction between the different junction electrodes to be reduced even if the misalignment occurs in bonding the first substrate 10 and the second substrate 20 to each other. This helps to reduce the pixel size.

Hereinafter, a description is given of Modification Examples 1 to 11, an application example, and practical application examples of the imaging device 1 according to the above-described embodiment. It is to be noted that the same reference numerals are given to configurations common to the above-described embodiment in the following modification examples.

### <2. Modification Examples>

### (2-1. Modification Example 1)

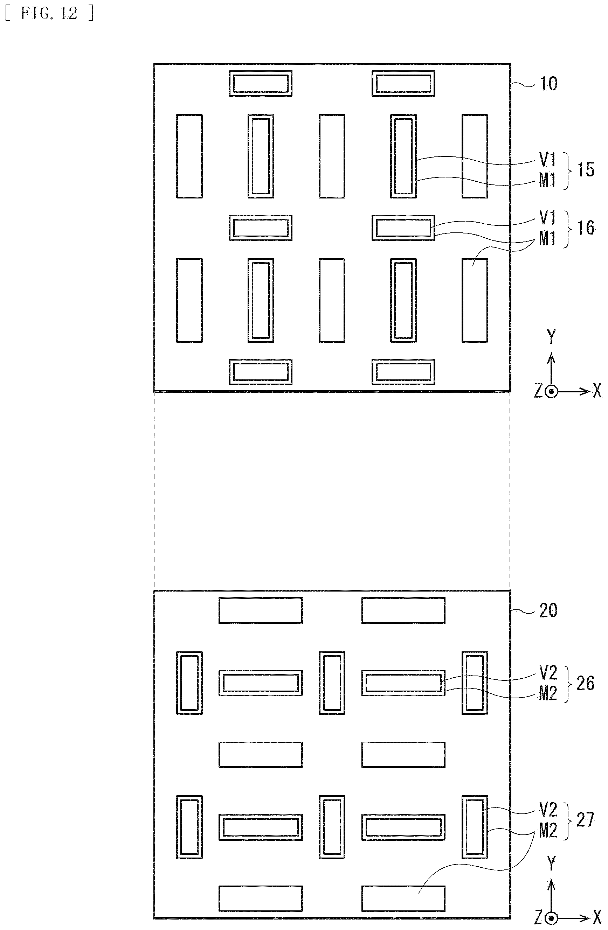

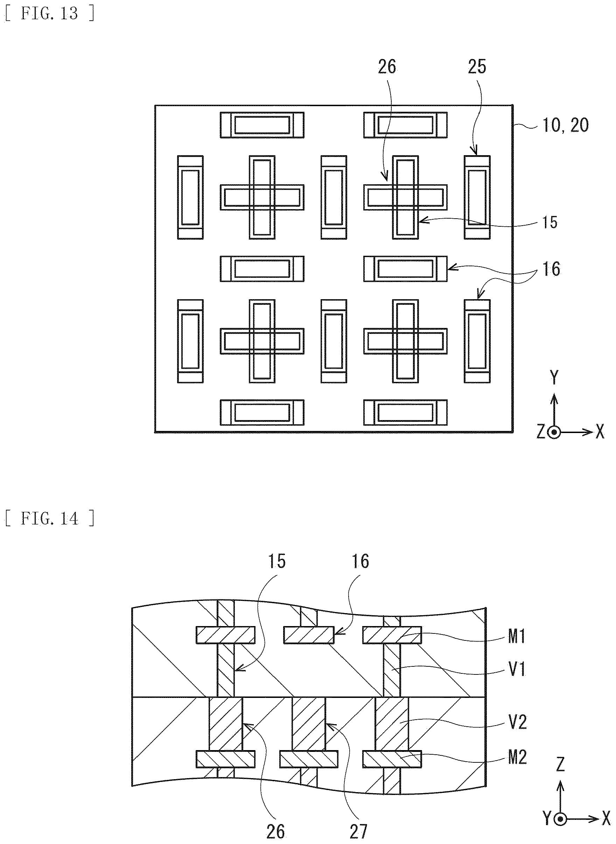

FIG. 12 illustrates an example of a cross-sectional configuration in the horizontal direction of the first substrate 10 and the second substrate 20 according to Modification Example 1 of the present disclosure. FIG. 13 illustrates a cross-sectional configuration in the horizontal direction when the first substrate 10 and the second substrate 20 illustrated in FIG. 12 are joined to each other. FIG. 14 illustrates a cross-sectional configuration in the vertical direction of the imaging device illustrated in FIG. 13.

For example, as illustrated in FIG. 7, the above-described embodiment indicates the example in which the plurality of FD junction electrodes 17, the plurality of FD junction electrodes 24, the plurality of VSS junction electrodes 18, and the plurality of VSS junction electrodes 25 each having a substantially rectangular shape having long sides in a corresponding one of the directions substantially orthogonal to each other (e.g., the X-axis direction or the Y-axis direction) are provided, on the junction surfaces, respectively to the plurality of FD through-wiring lines 15 and 26 and the plurality of VSS through-wiring lines 16 and 27. In the example, the plurality of FD through-wiring lines 15 and 26 and the plurality of VSS through-wiring lines 16 and 27 each include the via V1 or V2 and the metal layer M1 or M2, and the via V1 and V2 are narrower than the respective junction electrodes. However, the present disclosure is not limited thereto.

For example, the first substrate 10 and the second substrate 20 may be electrically coupled to each other by coupling to each other the vias V1 and V2 constituting the respective FD through-wiring lines 15 and 26. At this time, planar shapes of the vias V1 and V2 are similar to the shapes of the plurality of FD junction electrodes 17, the plurality of FD junction electrodes 24, the plurality of VSS junction electrodes 18, and the plurality of VSS junction electrodes 25 in the above-described embodiment.

### (2-2. Modification Example 2)

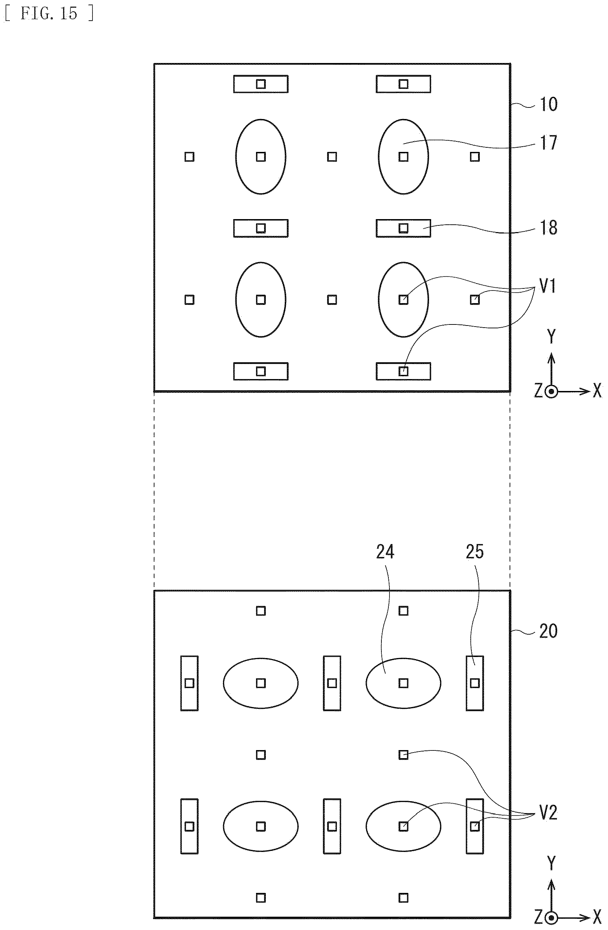

FIG. 15 illustrates an example of a cross-sectional configuration in the horizontal direction of the first substrate 10 and the second substrate 20 according to Modification Example 2 of the present disclosure. The above-described embodiment indicates the example in which the plurality of FD junction electrodes 17 and the plurality of FD junction electrodes 24 have substantially rectangular shapes. However, the shapes of the plurality of FD junction electrodes 17 and the plurality of FD junction electrodes 24 are not limited thereto.

It is sufficient for the shapes of the plurality of FD junction electrodes 17 and the plurality of FD junction electrodes 24 to be each a planar shape having a longitudinal direction in a corresponding one of the directions substantially orthogonal to each other (e.g., the X-axis direction or the Y-axis direction). The plurality of FD junction electrodes 17 and the plurality of FD junction electrodes 24 may each have a substantially elliptical shape having a major axis in a corresponding one of the directions substantially orthogonal to each other (e.g., the X-axis direction or the Y-axis direction), as illustrated in FIG. 15, for example.

It is to be noted that each of the VSS junction electrodes 18 and 25 may similarly have, for example, a substantially elliptical shape having a major axis in a corresponding one of the directions substantially orthogonal to each other (e.g., the X-axis direction or the Y-axis direction).

### (2-3. Modification Example 3)

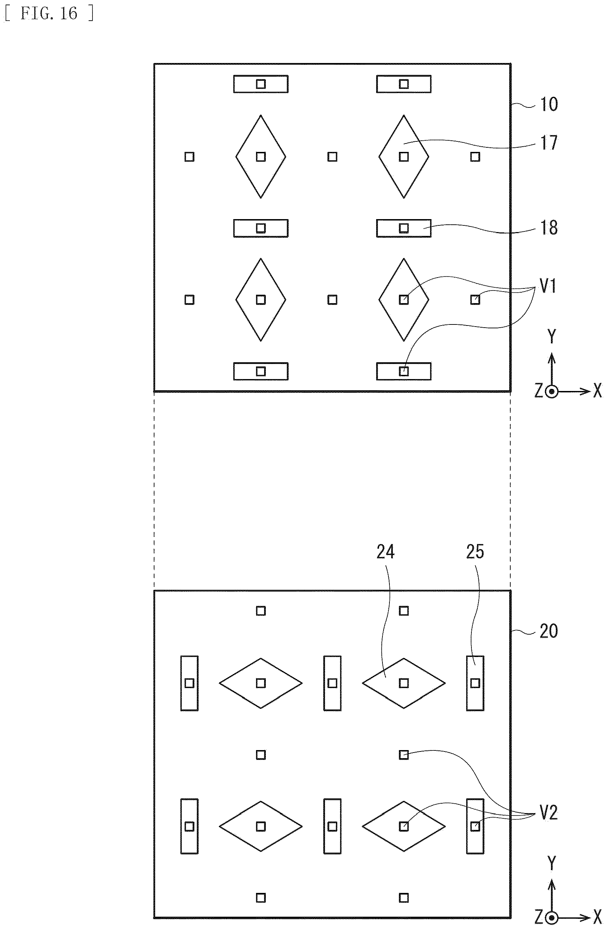

FIG. 16 illustrates an example of a cross-sectional configuration in the horizontal direction of the first substrate 10 and the second substrate 20 according to Modification Example 3 of the present disclosure. The above-described embodiment indicates the example in which the plurality of FD junction electrodes 17 and the plurality of FD junction electrodes 24 have substantially rectangular shapes. However, the shapes of the plurality of FD junction electrodes 17 and the plurality of FD junction electrodes 24 are not limited thereto.

It is sufficient for the shapes of the plurality of FD junction electrodes 17 and the plurality of FD junction electrodes 24 to be each a planar shape having a longitudinal direction in a corresponding one of the directions substantially orthogonal to each other (e.g., the X-axis direction or the Y-axis direction). The plurality of FD junction electrodes 17 and the plurality of FD junction electrodes 24 may each have a substantially rhombic shape in which a diagonal extending in one of the directions substantially orthogonal to each other (e.g., the X-axis direction or the Y-axis direction) is longer than a diagonal extending in another one of the directions, as illustrated in FIG. 16, for example.

It is to be noted that each of the VSS junction electrodes 18 and 25 may have, for example, a substantially rhombic shape in which a diagonal extending in one of the directions substantially orthogonal to each other (e.g., the X-axis direction or the Y-axis direction) is longer than a diagonal extending in another one of the directions.

### (2-4. Modification Example 4)

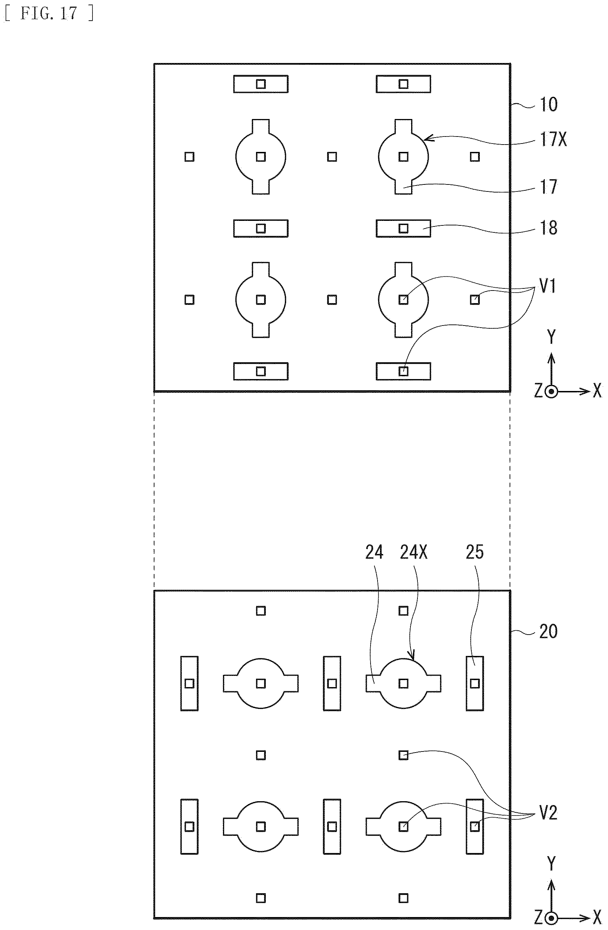

FIG. 17 illustrates an example of a cross-sectional configuration in the horizontal direction of the first substrate 10 and the second substrate 20 according to Modification Example 4 of the present disclosure. The above-described embodiment indicates the example in which the plurality of FD junction electrodes 17 and the plurality of FD junction electrodes 24 have substantially rectangular shapes. However, the shapes of the plurality of FD junction electrodes 17 and the plurality of FD junction electrodes 24 are not limited thereto.

For example, the plurality of FD junction electrodes 17 and the plurality of FD junction electrodes 24 may be each provided with a substantially circular wide part 17X or 24X substantially in a middle of the long sides opposed to each other, as illustrated in FIG. 17.

This increases a contact area between each of the FD junction electrodes 17 and a corresponding one of the FD junction electrodes 24, making it possible to reduce a probability of occurrence of a contact failure between each of the FD junction electrodes 17 and a corresponding one of the FD junction electrodes 24. This makes it possible to improve reliability, in addition to the effects of the above-described embodiment.

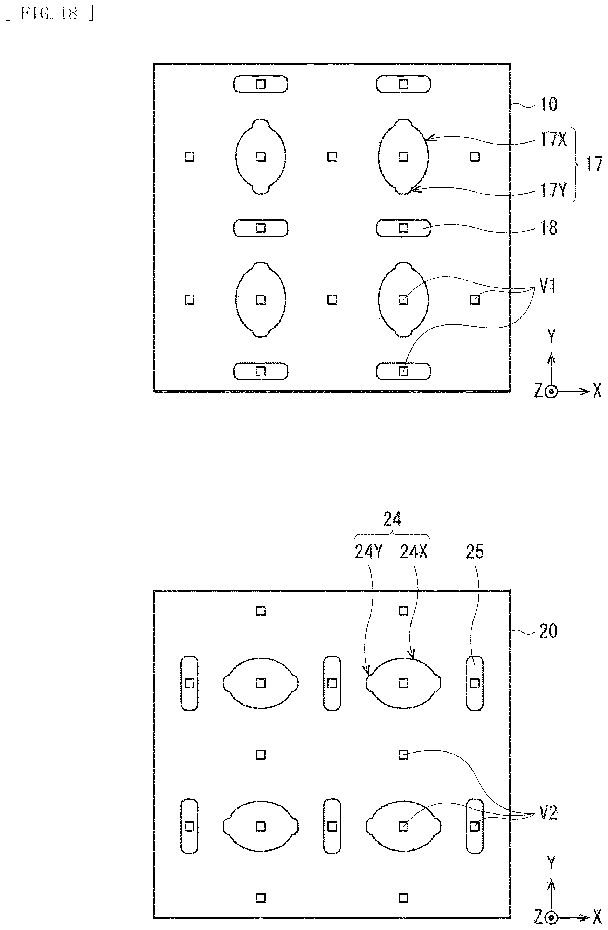

It is to be noted that FIG. 18 illustrates a cross-sectional configuration in the horizontal direction of the first substrate and the second substrate, which is actually envisaged in the imaging device illustrated in FIG. 17. The plurality of FD junction electrodes 17 and the plurality of FD junction electrodes 24 each have a shape including protrusions 17Y or 24Y each protruding in one direction (e.g., the X-axis direction or the Y-axis direction) with respect to the substantially circular wide part 17X or 24X. Inflection points are each formed between the wide part 17X and the protrusion 17Y or between the wide part 24X and the protrusion 24Y

### (2-5. Modification Example 5)

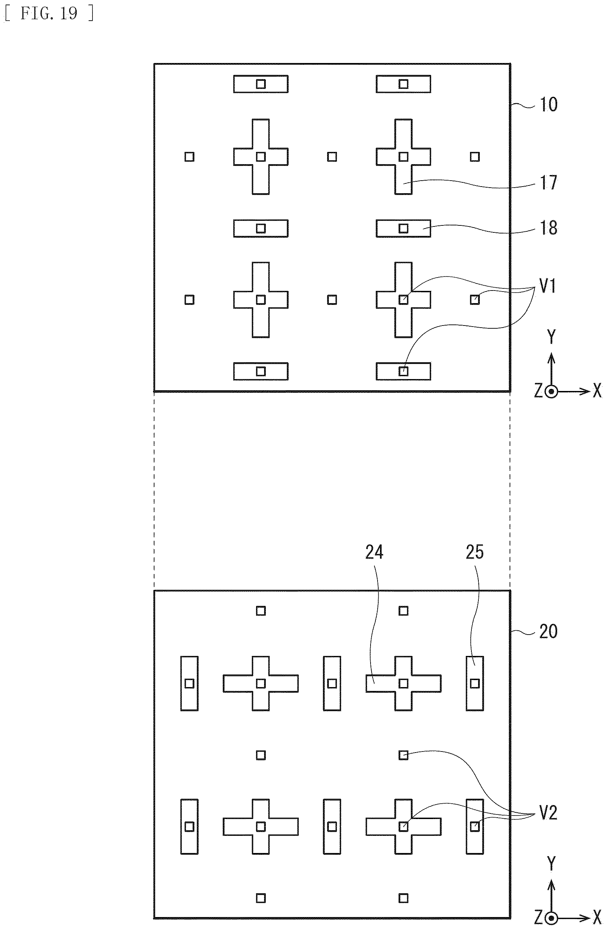

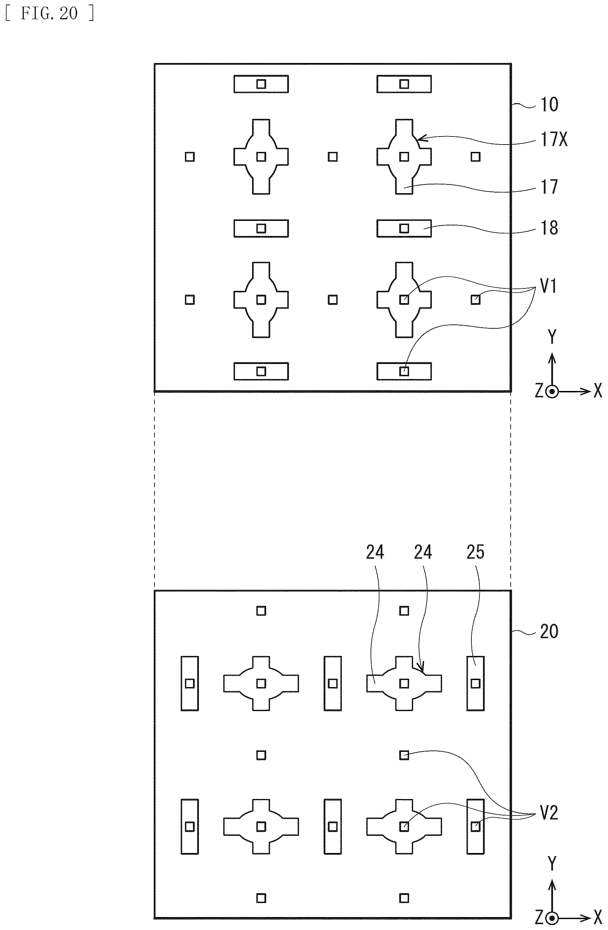

FIG. 19 illustrates an example of a cross-sectional configuration in the horizontal direction of the first substrate 10 and the second substrate 20 according to Modification Example 5 of the present disclosure. FIG. 20 illustrates another example of the cross-sectional configuration in the horizontal direction of the first substrate 10 and the second substrate 20 according to Modification Example 5 of the present disclosure. The above-described embodiment indicates the example in which the plurality of FD junction electrodes 17 and the plurality of FD junction electrodes 24 have substantially rectangular shapes. However, the shapes of the plurality of FD junction electrodes 17 and the plurality of FD junction electrodes 24 are not limited thereto.

For example, the plurality of FD junction electrodes 17 and the plurality of FD junction electrodes 24 may each have a cross shape in which straight portions each extending in the X-axis direction or the Y-axis direction differ in length from each other, as illustrated in FIG. 19.

Further, the substantially circular wide part 17X or 24X may be provided substantially in a middle of the plurality of FD junction electrodes 17 or the plurality of FD junction electrodes 24 each having a cross shape, in combination with Modification Example 4 described above, as illustrated in FIG. 20. It is to be noted that the wide parts 17X and 24X do not necessarily have to be circular. In actuality, such a shape is envisaged that the wide part 17X or 24X widens between the straight portions constituting the cross shape, and each of the sides of each of the plurality of FD junction electrodes 17 and the plurality of FD junction electrodes 24 each having a substantially rhombic shape illustrated in FIG. 16 is recessed toward a center thereof, for example.

This increases the contact area between each of the FD junction electrodes 17 and a corresponding one of the FD junction electrodes 24, making it possible to reduce the probability of occurrence of the contact failure between each of the FD junction electrodes 17 and a corresponding one of the FD junction electrodes 24. This makes it possible to improve the reliability, in addition to the effects of the above-described embodiment.

### (2-6. Modification Example 6)

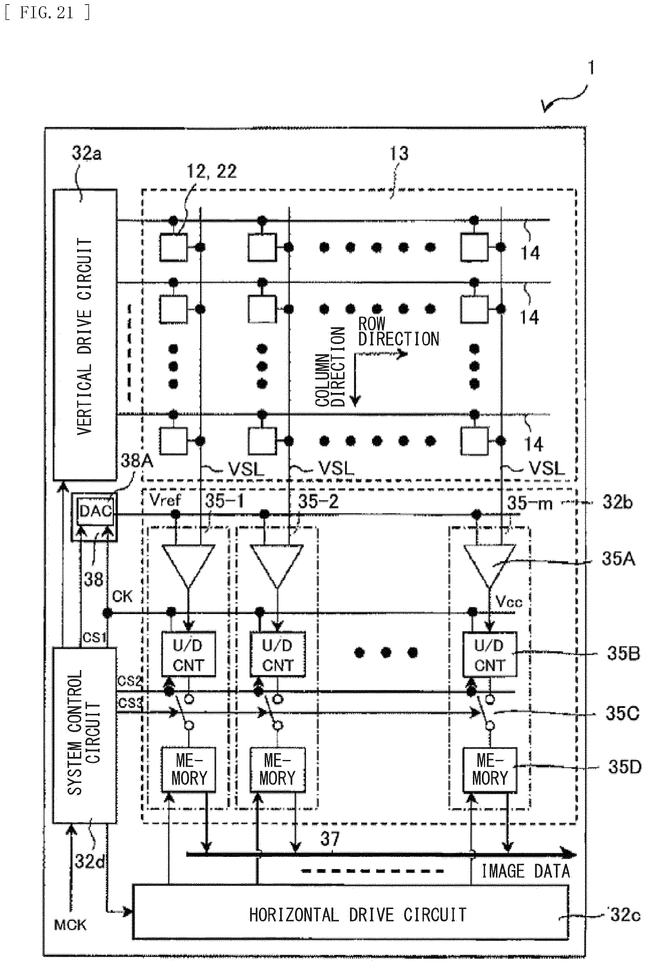

FIG. 21 illustrates an example of a circuit configuration of the imaging device 1 according to any of the above-described embodiment or Modification Example 6 thereof. The imaging device 1 according to the present modification example is a CMOS image sensor incorporating a column parallel ADC.

The imaging device 1 according to the present modification example includes the vertical drive circuit 32a, the column signal processing circuit 32b, a reference voltage supplier 38, the horizontal drive circuit 32c, a horizontal output line 37, and the system control circuit 32d, in addition to the pixel region 13, as illustrated in FIG. 21. In the pixel region 13, the plurality of sensor pixels 12 including photoelectric conversion elements is disposed two-dimensionally in a matrix pattern (in a matrix shape).

In this system configuration, the system control circuit 32d generates, on the basis of a master clock MCK, clock signals, control signals, and the like adapted to serve as reference for an operation of the vertical drive circuit 32a, the column signal processing circuit 32b, the reference voltage supplier 38, the horizontal drive circuit 32c, and the like. The system control circuit 32d gives such signals to the vertical drive circuit 32a, the column signal processing circuit 32b, the reference voltage supplier 38, the horizontal drive circuit 32c, and the like.

Further, the vertical drive circuit 32a is formed in the first substrate 10 along with each of the sensor pixels 12 in the pixel region 13, and is also formed in the second substrate 20 including the readout circuit 22. The column signal processing circuit 32b, the reference voltage supplier 38, the horizontal drive circuit 32c, the horizontal output line 37, and the system control circuit 32d are formed in the third substrate 30.

For the sensor pixel 12, it is possible to use a configuration (not illustrated herein) including, for example, the transfer transistor TR that transfers, to the floating diffusion FD, electric charge obtained through photoelectric conversion performed by the photodiode PD, in addition to the photodiode PD. Further, for the readout circuit 22, it is possible to use, for example, a three-transistor configuration (not illustrated herein) including the reset transistor RST that controls a potential of the floating diffusion FD, the amplification transistor AMP that outputs a signal corresponding to the potential of the floating diffusion FD, and the selection transistor SEL that serves to perform pixel selection.

In the pixel region 13, the sensor pixels 12 are disposed two-dimensionally. In addition, the drive wiring line 14 is wired for each of the rows, and the vertical signal line VSL is wired for each of the columns, in this pixel arrangement having m rows and n columns. One end of each of the plurality of drive wiring lines 14 is coupled to each of output ends corresponding to each of the rows of the vertical drive circuit 32a. The vertical drive circuit 32a includes a shift register or the like, and controls row addresses and row scanning of the pixel region 13 through the plurality of drive wiring lines 14.

The column signal processing circuit 32b includes, for example, ADCs (analog-to-digital conversion circuits) 35-1 to 35-m provided for respective pixel columns of the pixel region 13, i.e., for the respective vertical signal lines VSL. Each of the ADCs converts, into a digital signal, an analog signal outputted from each of the sensor pixels 12 in the pixel region 13 for each of the columns, and outputs the digital signal.

The reference voltage supplier 38 includes, for example, a DAC (a digital-to-analog conversion circuit) 38A as a section of generating a reference voltage Vref of a so-called ramp (RAMP) waveform whose level varies in a slope shape over time. It is to be noted that the section of generating the reference voltage Vref of the ramp waveform is not limited to the DAC 38A.

The DAC 38A generates the reference voltage Vref of the ramp waveform on the basis of a clock CK given from the system control circuit 32d under the control of a control signal CS1 given from the system control circuit 32d to supply the resulting voltage to the ADCs 35-1 to 35-m in the column signal processing circuit 32b.

It is to be noted that each of the ADCs 35-1 to 35-m is configured to selectively enable an AD conversion operation corresponding to each of operation modes including a normal frame rate mode and a high-speed frame rate mode. The normal frame rate mode is performed in a progressive scanning method of reading information concerning all the sensor pixels 12. The high-speed frame rate mode sets exposure time of the sensor pixels 12 to 1/N to raise a frame rate N times, for example, twice, as compared with the normal frame rate mode. Switching between these operation modes is performed under the control of control signals CS2 and CS3 given from the system control circuit 32d. Further, the system control circuit 32d is given, from an external system controller (not illustrated), information concerning instructions for switching between the respective operation modes, i.e., between the normal frame rate mode and the high-speed frame rate mode.

All the ADCs 35-1 to 35-m have the same configuration, and a description is given herein by citing the ADC 35-m as an example. The ADC 35-m includes a comparator 35A, an up/down counter (denoted as U/DCNT in the drawing) 35B as an example of a counting section, a transfer switch 35C, and a memory 35D.

The comparator 35A compares a signal voltage Vx of the vertical signal line VSL corresponding to a signal outputted from each of the sensor pixels 12 of an n-th column in the pixel region 13 with the reference voltage Vref of the ramp waveform supplied from the reference voltage supplier 38. For example, an output Vco is brought into an "H" level when the reference voltage Vref is greater than the signal voltage Vx, and the output Vco is brought into an "L" level when the reference voltage Vref is equal to or less than the signal voltage Vx.

The up/down counter 35B is an asynchronous counter. The clock CK is given from the system control circuit 32d to the up/down counter 35B simultaneously with the DAC 38A, under the control of the control signal CS2 given from the system control circuit 32d. In synchronization with the clock CK, the up/down counter 35B performs down (DOWN) count or up (UP) count, thereby measuring a comparation period of time from a start of a comparison operation by the comparator 35A until an end of the comparison operation.

Specifically, in the normal frame rate mode, the up/down counter 35B, in an operation of reading a signal from one sensor pixel 12, measures comparation time at the time of first reading by performing down count during a first operation of reading, and measures comparation time at the time of second reading by performing up count during a second operation of reading.

Meanwhile, in the high-speed frame rate mode, the up/down counter 35B holds a count result of the sensor pixels 12 of a certain row as it is, continues to measure, for the sensor pixels 12 of the next row, comparation time at the time of the first reading by performing down count from the previous count result during the first operation of reading, and measures comparation time at the time of the second reading by performing up count during the second operation of reading.

In the normal frame rate mode, the transfer switch 35C, under the control of the control signal CS3 given from the system control circuit 32d, is brought into an on (closed) state at the time of completion of a count operation by the up/down counter 35B for the sensor pixels 12 of a certain row to transfer to the memory 35D a count result of the up/down counter 35B.

Meanwhile, in the high-speed frame rate of, for example, N = 2, the transfer switch 35C remains in an off (open) state at the time of the completion of the count operation by the up/down counter 35B for the sensor pixels 12 of a certain row, and is continuously brought into the on state at the time of the completion of the count operation by the up/down counter 35B for the sensor pixels 12 of the next row to transfer to the memory 35D a count result of two vertical pixels from the up/down counter 35B.

In such a manner, analog signals supplied, for each of the columns, from each of the sensor pixels 12 in the pixel region 13 through the vertical signal line VSL are converted into N-bit digital signals by each of the operations by the comparator 35A and the up/down counter 35B in each of the ADCs 35-1 to 35-m to be stored in the memory 35D.

The horizontal drive circuit 32c includes a shift register or the like, and controls column addresses and column scanning of the ADCs 35-1 to 35-m in the column signal processing circuit 32b. Under the control of the horizontal drive circuit 32c, the N-bit digital signals having been subjected to AD conversion by each of the ADCs 35-1 to 35-m are sequentially read to the horizontal output line 37 to be outputted as imaging data through the horizontal output line 37.

It is to be noted that a circuit and the like that perform a variety of signal processing on the imaging data outputted through the horizontal output line 37 are not particularly illustrated because they are not directly related to the present disclosure; however, it is possible to provide such a circuit and the like in addition to the above-described components.

The imaging device 1 incorporating the column parallel ADC according to the present modification example of the above-described configuration allows the count result of the up/down counter 35B to be selectively transferred to the memory 35D through the transfer switch 35C. This makes it possible to independently control the count operation by the up/down counter 35B and the operation of reading the count result of the up/down counter 35B to the horizontal output line 37.

### (2-7. Modification Example 7)

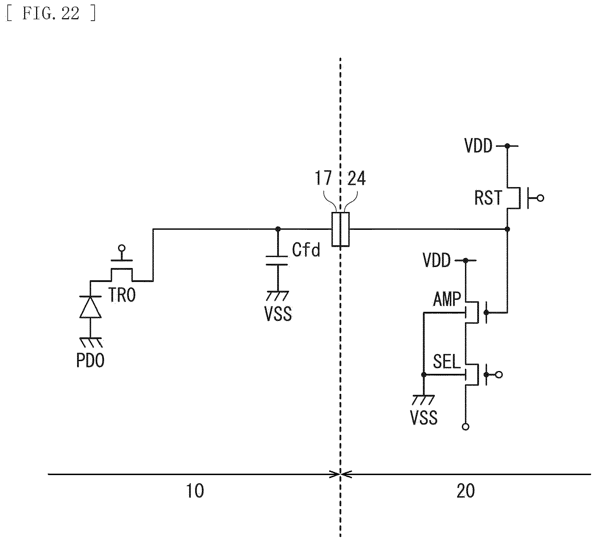

FIG. 22 illustrates an example of a configuration of the sensor pixel and the readout circuit of the imaging device 1 according to any of the above-described embodiment or Modification Example 7 of the present disclosure. The above-described embodiment indicates the example in which four sensor pixels 12 share one readout circuit 22; however, the present disclosure is not limited thereto.

One readout circuit 22 may be provided for each of the sensor pixels 12, as illustrated in FIG. 22, for example. In FIG. 22, one photodiode PD0 and one transfer transistor TR0 are disposed for one floating diffusion FD, and the reference potential (GND or VSS) is applied to both the respective shield wiring lines (e.g., the VSS through-wiring lines 16 and 27) separated from each other between the first substrate 10 and the second substrate 20.

### (2-8. Modification Example 8)

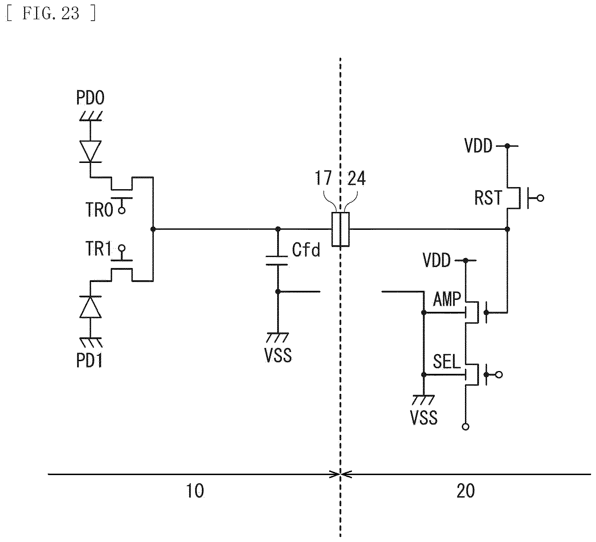

FIG. 23 illustrates an example of a configuration of the sensor pixels and the readout circuit of the imaging device 1 according to any of the above-described embodiment or Modification Example 8 of the present disclosure. The above-described embodiment indicates the example in which four sensor pixels 12 share one readout circuit 22; however, the present disclosure is not limited thereto.

One readout circuit 22 may be provided for every two sensor pixels 12, as illustrated in FIG. 23, for example. In FIG. 23, two photodiodes PD0 and PD1 and one transfer transistor TR0 or TR1 are each disposed for one floating diffusion FD, and the reference potential (GND or VSS) is applied to both the respective shield wiring lines (e.g., the VSS through-wiring lines 16 and 27) separated from each other between the first substrate 10 and the second substrate 20.

### (2-9. Modification Example 9)

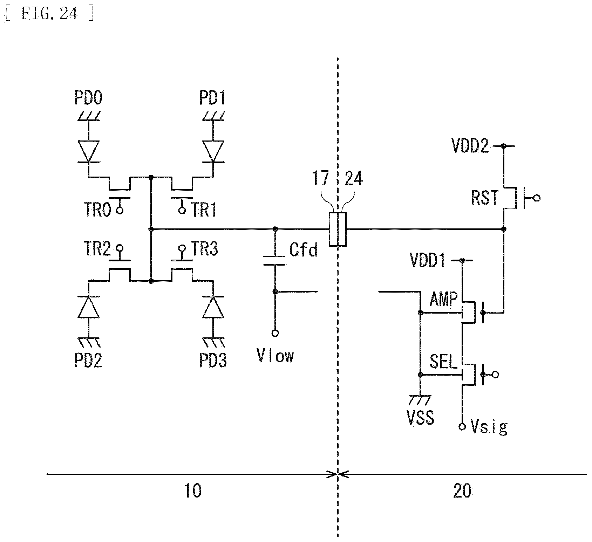

FIG. 24 illustrates an example of a configuration of the sensor pixels and the readout circuit of the imaging device 1 according to any of the above-described embodiment or Modification Example 9 of the present disclosure. The above-described embodiment indicates the example in which the reference potential VSS is applied to the shield wiring line (e.g., the VSS through-wiring line 27) on the side of the second substrate 20; however, the present disclosure is not limited thereto.

For example, as illustrated in FIG. 24, one readout circuit 22 may be provided for every four sensor pixels 12. The reference potential (GND or VSS) may be applied to the shield wiring line (e.g., the VSS through-wiring line 27) on the side of the second substrate 20. Another voltage may be applied to the shield wiring line (e.g., the VSS through-wiring line 16) on a side of the first substrate 10. For example, a voltage lower than VSS may be applied thereto. In addition, different voltages may be applied, as a power supply voltage of the second substrate 20, to a power supply (VDD1) of the amplification transistor AMP and a power supply (VDD2) of the reset transistor RST.

### (2-10. Modification Example 10)

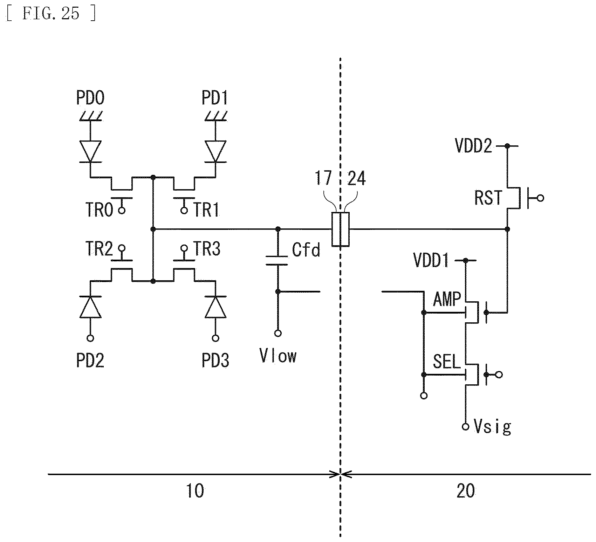

FIG. 25 illustrates an example of a configuration of the sensor pixels and the readout circuit of the imaging device 1 according to any of the above-described embodiment or Modification Example 10 of the present disclosure. The above-described embodiment indicates the example in which the reference potential (GND or VSS) is applied to the shield wiring line (e.g., the VSS through-wiring line 16) on the side of the first substrate 10, and the reference potential VSS is applied to the shield wiring line (e.g., the VSS through-wiring line 27) on the side of the second substrate 20; however, the present disclosure is not limited thereto.

For example, as illustrated in FIG. 25, one readout circuit 22 may be provided for every four sensor pixels 12. The reference potential (GND or VSS) may be applied to the shield wiring line (e.g., the VSS through-wiring line 16) on the side of the first substrate 10. Another voltage may be applied to the shield wiring line (e.g., the VSS through-wiring line 27) on the side of the second substrate 20. For example, a voltage lower than VSS may be applied thereto. In addition, different voltages may be applied, as a power supply voltage of the first substrate 10, to the power supply (VDD1) of the amplification transistor AMP and the power supply (VDD2) of the reset transistor RST.

### (2-11. Modification Example 11)

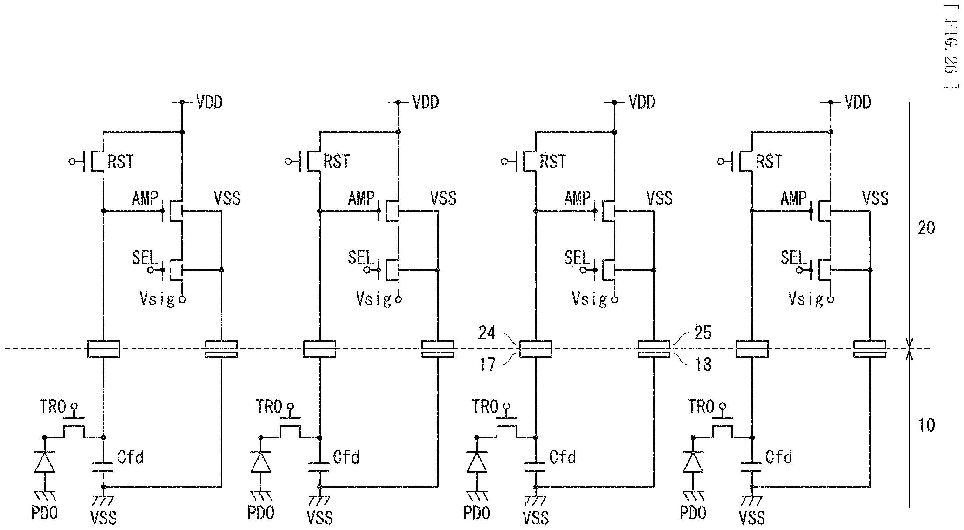

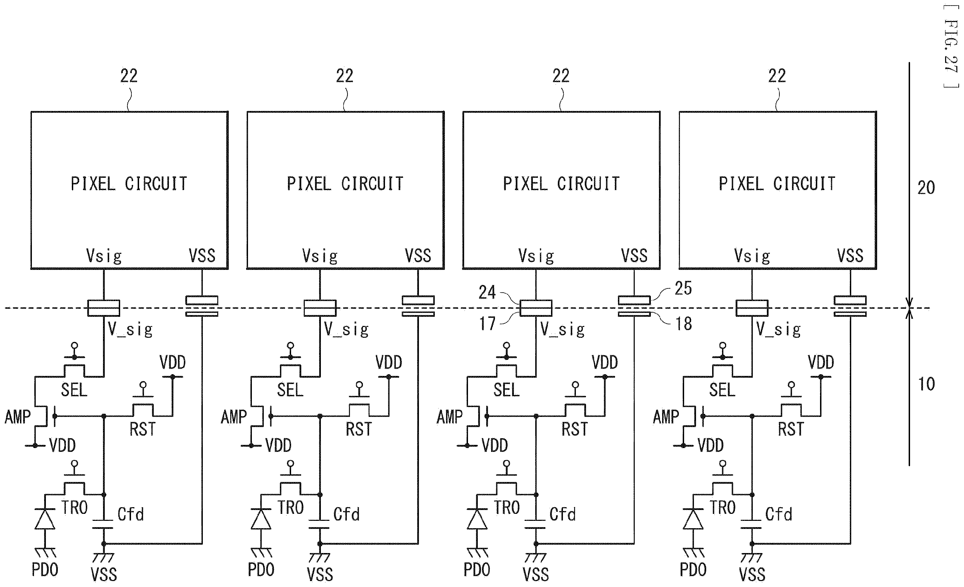

FIG. 26 illustrates an example of a mode of a coupling portion between the sensor pixels 12 and the readout circuits 22 of the imaging device 1 described in the above-described embodiment. FIG. 27 illustrates another example of the mode of the coupling portion between the sensor pixels 12 and the readout circuits 22 of the imaging device 1 according to Modification Example 12 of the present disclosure. FIG. 26 illustrates a case where the pixel signal is on a terminal of the floating diffusion FD. However, the pixel signal may be on an output terminal (e.g., Vsig) of the readout circuit 22, as illustrated in FIG. 27.

In a case of a structure in which the floating diffusion FD is coupled between the two silicon substrates (between the semiconductor substrate 11 and the semiconductor substrate 21) as illustrated in FIG. 26, there is a possibility that capacitance between the terminal of the floating diffusion FD and another terminal may increase to reduce conversion efficiency of the pixel. Meanwhile, in a case of a structure in which an output terminal of the amplification transistor AMP is coupled between the two silicon substrates as in the present modification example, capacitance of the terminal of the floating diffusion FD is equivalent to that of a typical imaging device. This makes it possible to prevent reduction in the conversion efficiency.

### (Other Modification Examples)

Further, two or more of these modification examples may be combined.

### <3. Application Example>

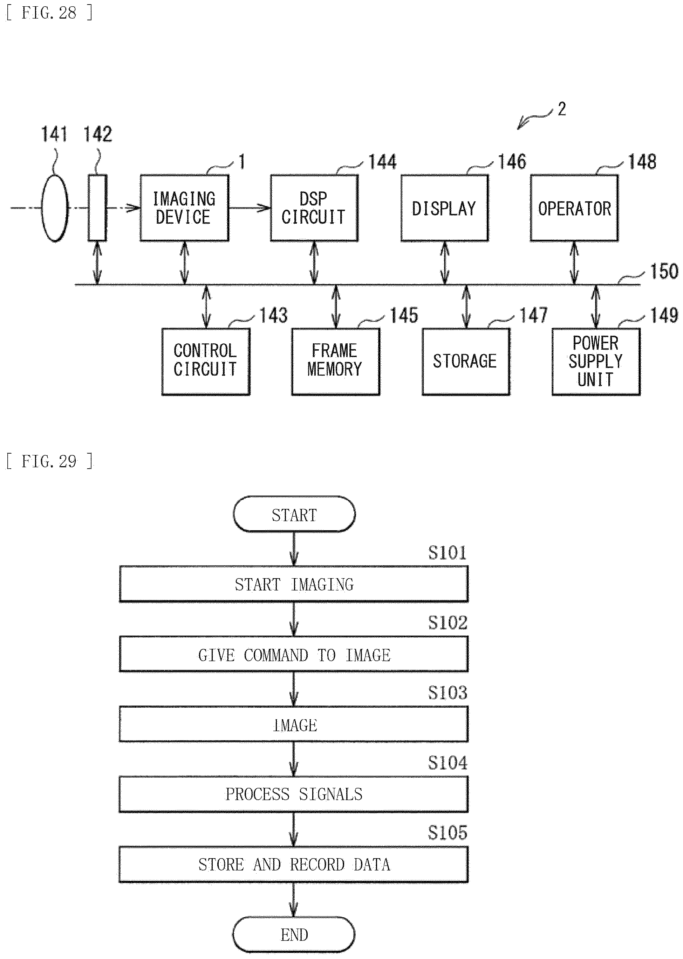

FIG. 28 illustrates an example of a schematic configuration of an imaging system 3 including the imaging device 1 according to any of the above-described embodiment or the modification examples thereof.

The imaging system 3 is, for example, an electronic apparatus including an imaging apparatus such as a digital still camera or a video camera, or a mobile terminal apparatus such as a smartphone or a tablet terminal. The imaging system 3 includes, for example, the imaging device 1 according to any of the above-described embodiment or the modification examples thereof, an optical system 141, a shutter device 142, a control circuit 143, a DSP circuit 144, a frame memory 145, a display 146, a storage 147, an operator 148, and a power supply unit 149. In the imaging system 3, the imaging device 1 according to any of the above-described embodiment or the modification examples thereof, the DSP circuit 144, the frame memory 145, the display 146, the storage 147, the operator 148, and the power supply unit 149 are coupled to each other through a bus line 150.

The optical system 141 includes one or more lenses, and guides light (incident light) from a subject to the imaging device 1 to form an image on a light-receiving surface of the imaging device 1. The shutter device 142 is disposed between the optical system 141 and the imaging device 1, and controls a period of irradiating the imaging device 1 with light and a period of blocking light into the imaging device 1 in accordance with control of the control circuit 143. The imaging device 1 accumulates signal charge for a predetermined period of time depending on light whose image is formed on the light-receiving surface through the optical system 141 and the shutter device 142. The signal charge accumulated in the imaging device 1 is transferred as image data in accordance with a drive signal (a timing signal) supplied from the control circuit 143. The control circuit 143 outputs the drive signal that controls a transfer operation of the imaging device 1 and a shutter operation of the shutter device 142 to drive the imaging device 1 and the shutter device 142.

The DSP circuit 144 is a signal processing circuit that processes the image data outputted from the imaging device 1. The frame memory 145 temporarily holds the image data processed by the DSP circuit 144 on a frame-by-frame basis. The display 146 includes, for example, a panel display unit such as a liquid crystal panel or an organic EL (Electro Luminescence) panel, and displays moving images or still images captured by the imaging device 1. The storage 147 records the image data of the moving images or still images captured by the imaging device 1 on a recording medium such as a semiconductor memory or a hard disk. The operator 148 issues operation commands for various functions of the imaging system 3 in accordance with an operation by a user. The power supply unit 149 supplies the imaging device 1, the DSP circuit 144, the frame memory 145, the display 146, the storage 147, and the operator 148 with various types of power as power for operating these supply targets as appropriate.

Next, a description is given of imaging steps in the imaging system 3.

FIG. 29 illustrates an example of a flowchart of an imaging operation in the imaging system 3. A user gives an instruction to start imaging by operating the operator 148 (step S101). Thereafter, the operator 148 transmits the imaging command to the control circuit 143 (step S102). Upon reception of the imaging command, the control circuit 143 starts control of the shutter device 142 and the imaging device 1. The imaging device 1 (specifically, the system control circuit 32d) performs imaging by a predetermined imaging method under the control of the control circuit 143 (step S103). The shutter device 142 controls a period of irradiating the imaging device 1 with light and a period of blocking light into the imaging device 1 under the control of the control circuit 143.

The imaging device 1 outputs image data obtained by imaging to the DSP circuit 144. Here, the image data refers to data for all pixels including pixel signals generated on the basis of electric charge held temporarily in the floating diffusions FD. The DSP circuit 144 performs predetermined signal processing (e.g., noise reduction processing) on the basis of the image data inputted from the imaging device 1 (step S104). The DSP circuit 144 causes the frame memory 145 to hold the image data having been subjected to the predetermined signal processing, and the frame memory 145 causes the storage 147 to store the image data (step S105). In such a manner, imaging in the imaging system 3 is performed.

In the present application example, the imaging device 1 according to any of the above-described embodiment or the modification examples thereof is applied to the imaging system 3. This allows the imaging device 1 to be made more compact, have a higher dynamic range, and have less noise, which makes it possible to provide the compact high-definition imaging system 3 having a wide dynamic range.

### <4. Practical Application Examples>

### [Practical Application Example 1]

A technique according to the present disclosure (the present technology) is applicable to various products. For example, the technique according to the present disclosure may be achieved as an apparatus to be mounted on any kind of a mobile body such as an automobile, an electric vehicle, a hybrid electric vehicle, a motorcycle, a bicycle, a personal mobility, an aircraft, a drone, a vessel, or a robot.

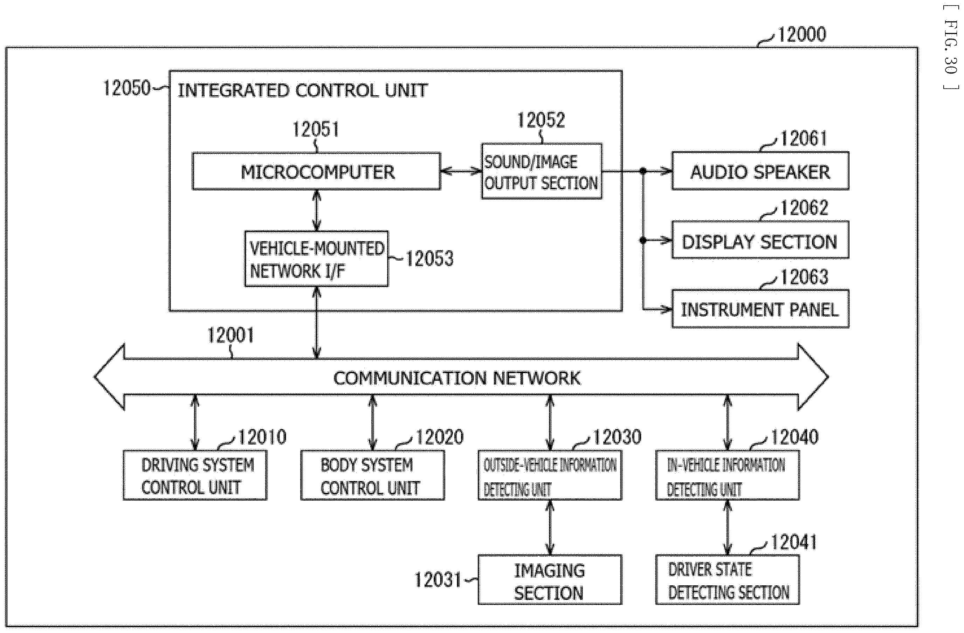

FIG. 30 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 30, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 30, an audio speaker 12061, a display section 12062, and an instrument panel 12063 are illustrated as the output device. The display section 12062 may, for example, include at least one of an on-board display and a head-up display.

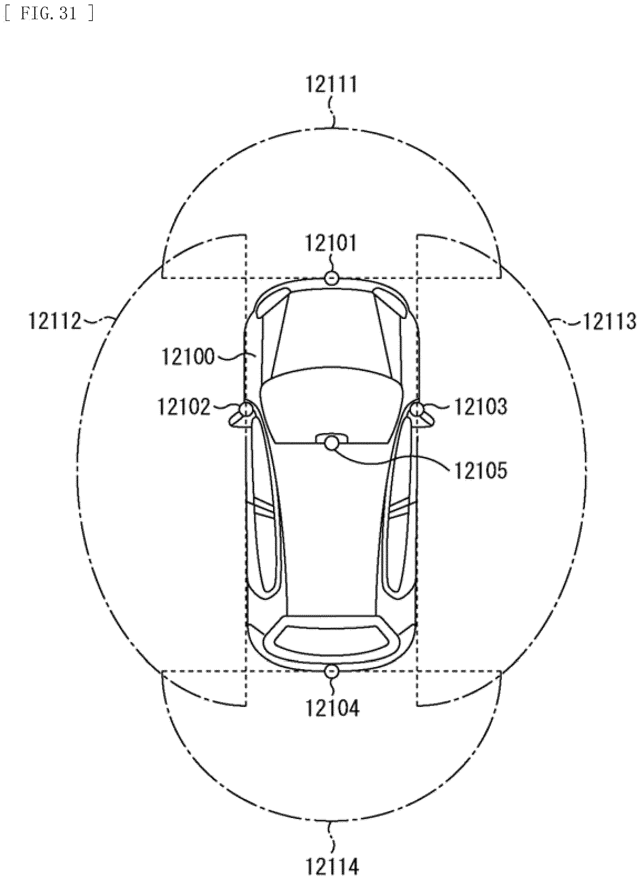

FIG. 31 is a diagram depicting an example of the installation position of the imaging section 12031.

In FIG. 31, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 31 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

As described above, the description has been given of an example of the mobile body control system to which the technique according to the present disclosure may be applied. Of the configurations described above, the technique according to the present disclosure may be applied to the imaging section 12031. Specifically, the imaging device 1 according to any of the above-described embodiment or the modification examples thereof may be applied to the imaging section 12031. Applying the technique according to the present disclosure to the imaging section 12031 makes it possible to obtain a captured image with higher definition and less noise. This helps to perform highly accurate control by using the captured image in the mobile body control system.

### [Practical Application Example 2]

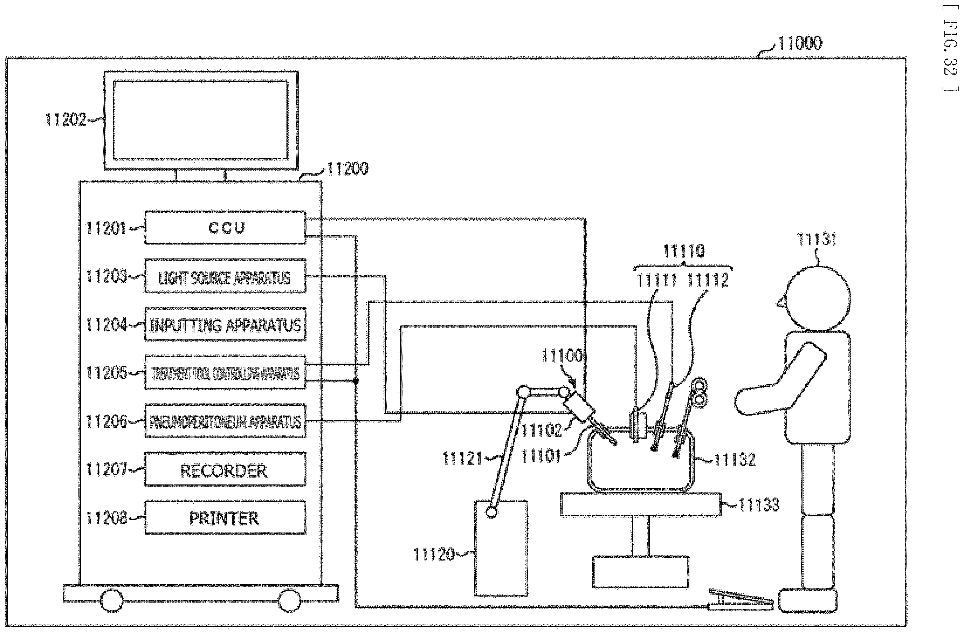

FIG. 32 is a view depicting an example of a schematic configuration of an endoscopic surgery system to which the technology according to an embodiment of the present disclosure (present technology) can be applied.

In FIG. 32, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

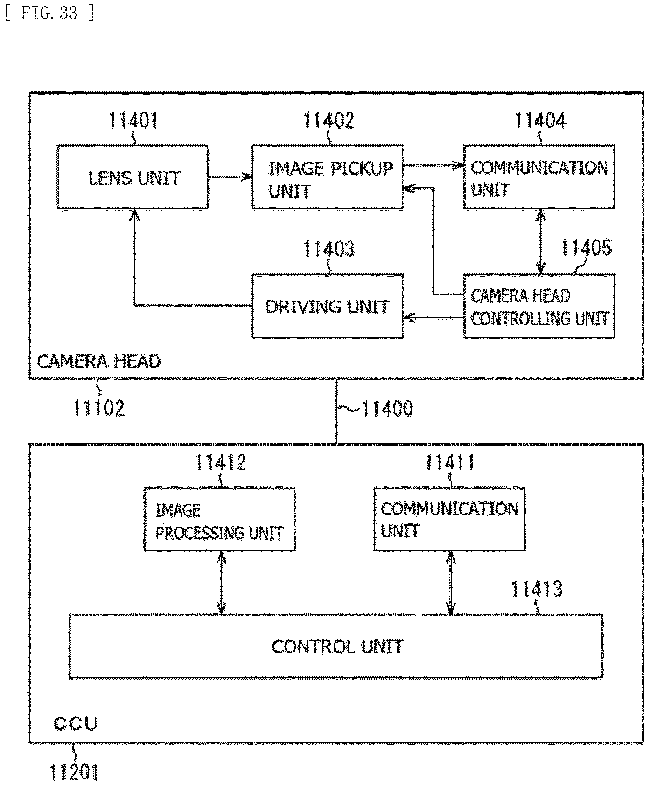

FIG. 33 is a block diagram depicting an example of a functional configuration of the camera head 11102 and the CCU 11201 depicted in FIG. 32.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

As described above, the description has been given of an example of the endoscopic surgery system to which the technique according to the present disclosure may be applied. Of the configurations described above, the technique according to the present disclosure may be preferably applied to the image pickup unit 11402 provided in the camera head 11102 of the endoscope 11100. Applying the technique according to the present disclosure to the image pickup unit 11402 allows the image pickup unit 11402 to be made more compact or have higher definition. This helps to provide the compact or high-definition endoscope 11100.

The present disclosure has been described above with reference to the embodiment, Modification Examples 1 to 11 thereof, the application example, and the practical application examples; however, the present disclosure is not limited to the above-described embodiment and the like, and may be modified in a variety of ways. It is to be noted that the effects described herein are merely exemplary. The effects of the present disclosure are not limited to the effects described herein. The present disclosure may have any effects other than the effects described herein.

It is to be noted that the present technology may also have the following configuration. According to the present technology of the following configuration, a plurality of first junction electrodes is provided on a junction surface of a first substrate with a second substrate and a plurality of second junction electrodes coupled to respective ones of the plurality of first junction electrodes is provided on a junction surface of the second substrate with the first substrate or on the junction surface of the first substrate with the second substrate in the first substrate and the second substrate that are stacked on each other. The plurality of first junction electrodes is coupled to each of one or more of sensor pixels, and each has a planar shape having a longitudinal direction in a first direction of the first direction and a second direction that are substantially orthogonal to each other. The plurality of second junction electrodes is coupled to respective ones of a plurality of readout circuits, and each has a planar shape having a longitudinal direction in the second direction of the first direction and the second direction that are substantially orthogonal to each other. Such a configuration increases a distance between adjacent junction electrodes to reduce capacitance between the adjacent junction electrodes. This makes it possible to provide an imaging device with a high image quality.
(1) An imaging device including:
   a first substrate including a pixel region including a plurality of sensor pixels that performs photoelectric conversion;
   a second substrate stacked on the first substrate and including a plurality of readout circuits, the plurality of readout circuits being each provided for every one or more of the sensor pixels and outputting a pixel signal based on electric charge outputted from the sensor pixels;
   a plurality of first junction electrodes provided on a junction surface of the first substrate with the second substrate and coupled to each of the one or more of the sensor pixels, the plurality of first junction electrodes each having a planar shape having a longitudinal direction in a first direction of the first direction and a second direction that are substantially orthogonal to each other; and
   a plurality of second junction electrodes provided on a junction surface of the second substrate with the first substrate, coupled to respective ones of the plurality of readout circuits, and coupled to respective ones of the plurality of first junction electrodes, the plurality of second junction electrodes each having a planar shape having a longitudinal direction in the second direction of the first direction and the second direction that are substantially orthogonal to each other.
(2) The imaging device according to (1), in which
   the first substrate includes a first interlayer insulating film on the junction surface with the second substrate,
   the second substrate includes a second interlayer insulating film on the junction surface with the first substrate, and
   the plurality of first junction electrodes and the plurality of second junction electrodes are each exposed on a surface of the first interlayer insulating film or the second interlayer insulating film.
(3) The imaging device according to (1) or (2), in which the plurality of first junction electrodes and the plurality of second junction electrodes each have a substantially rectangular shape having long sides in the first direction or the second direction.
(4) The imaging device according to (3), in which the plurality of first junction electrodes and the plurality of second junction electrodes each include a substantially circular wide part substantially in a middle of the long sides opposed to each other.
(5) The imaging device according to (1) or (2), in which the plurality of first junction electrodes and the plurality of second junction electrodes each have a substantially elliptical shape having a major axis in the first direction or the second direction.
(6) The imaging device according to (1) or (2), in which the plurality of first junction electrodes and the plurality of second junction electrodes each have a substantially rhombic shape in which a diagonal extending in one of the first direction or the second direction is longer than a diagonal extending in another one of the first direction or the second direction.
(7) The imaging device according to (1) or (2), in which
   the plurality of first junction electrodes and the plurality of second junction electrodes each have a substantially cross shape including a first straight part extending in the first direction and a second straight part extending in the second direction, and
   the first straight part and the second straight part have lengths that differ from each other.
(8) The imaging device according to (7), in which the plurality of first junction electrodes and the plurality of second junction electrodes each include a wide part that widens at an intersection of the first straight part and the second straight part.
(9) The imaging device according to any one of (1) to (8), in which the first substrate and the second substrate further include a plurality of first shield electrodes and a plurality of second shield electrodes, respectively, the plurality of first shield electrodes and the plurality of second shield electrodes being fixed to a reference potential.
(10) The imaging device according to (9), in which the plurality of first shield electrodes is provided on a side of the first substrate, and each has a planar shape having a longitudinal direction in the second direction of the first direction and the second direction that are substantially orthogonal to each other.
(11) The imaging device according to (10), in which the plurality of first shield electrodes is each provided between the plurality of first junction electrodes disposed side by side in the first direction.
(12) The imaging device according to any one of (9) to (11), in which the plurality of second shield electrodes is provided on a side of the second substrate, and each has a planar shape having a longitudinal direction in the first direction of the first direction and the second direction that are substantially orthogonal to each other.
(13) The imaging device according to (12), in which the plurality of second shield electrodes is each provided between the plurality of second junction electrodes disposed side by side in the second direction.
(14) The imaging device according to any one of (9) to (13), in which
   the first substrate includes a first interlayer insulating film on the junction surface with the second substrate,
   the second substrate includes a second interlayer insulating film on the junction surface with the first junction surface, and
   ones of the plurality of first shield electrodes or the plurality of second shield electrodes are provided in a film of the first interlayer insulating film or the second interlayer insulating film, and another ones of the plurality of first shield electrodes or the plurality of second shield electrodes are exposed on a surface of the first interlayer insulating film or the second interlayer insulating film.
(15) The imaging device according to any one of (1) to (14), in which the plurality of first junction electrodes is each disposed for one of the sensor pixels.
(16) The imaging device according to any one of (1) to (14), in which the plurality of first junction electrodes is each disposed for four of the sensor pixels disposed in two rows by two columns.
(17) The imaging device according to any one of (1) to (16), further including a third substrate including a control circuit that controls the sensor pixels and the readout circuits, in which the first substrate, the second substrate, and the third substrate are stacked in this order.

The present application claims the benefit of Japanese Priority Patent Application JP2021-201282 filed with the Japan Patent Office on December 10, 2021, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. An imaging device comprising:
a first substrate including a pixel region including a plurality of sensor pixels that performs photoelectric conversion;
a second substrate stacked on the first substrate and including a plurality of readout circuits, the plurality of readout circuits being each provided for every one or more of the sensor pixels and outputting a pixel signal based on electric charge outputted from the sensor pixels;
a plurality of first junction electrodes provided on a junction surface of the first substrate with the second substrate and coupled to each of the one or more of the sensor pixels, the plurality of first junction electrodes each having a planar shape having a longitudinal direction in a first direction of the first direction and a second direction that are substantially orthogonal to each other; and
a plurality of second junction electrodes provided on a junction surface of the second substrate with the first substrate, coupled to respective ones of the plurality of readout circuits, and coupled to respective ones of the plurality of first junction electrodes, the plurality of second junction electrodes each having a planar shape having a longitudinal direction in the second direction of the first direction and the second direction that are substantially orthogonal to each other.

2. The imaging device according to claim 1, wherein
the first substrate includes a first interlayer insulating film on the junction surface with the second substrate,
the second substrate includes a second interlayer insulating film on the junction surface with the first substrate, and
the plurality of first junction electrodes and the plurality of second junction electrodes are each exposed on a surface of the first interlayer insulating film or the second interlayer insulating film.

3. The imaging device according to claim 1, wherein the plurality of first junction electrodes and the plurality of second junction electrodes each have a substantially rectangular shape having long sides in the first direction or the second direction.

4. The imaging device according to claim 3, wherein the plurality of first junction electrodes and the plurality of second junction electrodes each include a substantially circular wide part substantially in a middle of the long sides opposed to each other.

5. The imaging device according to claim 1, wherein the plurality of first junction electrodes and the plurality of second junction electrodes each have a substantially elliptical shape having a major axis in the first direction or the second direction.

6. The imaging device according to claim 1, wherein the plurality of first junction electrodes and the plurality of second junction electrodes each have a substantially rhombic shape in which a diagonal extending in one of the first direction or the second direction is longer than a diagonal extending in another one of the first direction or the second direction.

7. The imaging device according to claim 1, wherein
the plurality of first junction electrodes and the plurality of second junction electrodes each have a substantially cross shape including a first straight part extending in the first direction and a second straight part extending in the second direction, and
the first straight part and the second straight part have lengths that differ from each other.

8. The imaging device according to claim 7, wherein the plurality of first junction electrodes and the plurality of second junction electrodes each include a wide part that widens at an intersection of the first straight part and the second straight part.

9. The imaging device according to claim 1, wherein the first substrate and the second substrate further include a plurality of first shield electrodes and a plurality of second shield electrodes, respectively, the plurality of first shield electrodes and the plurality of second shield electrodes being fixed to a reference potential.

10. The imaging device according to claim 9, wherein the plurality of first shield electrodes is provided on a side of the first substrate, and each has a planar shape having a longitudinal direction in the second direction of the first direction and the second direction that are substantially orthogonal to each other.

11. The imaging device according to claim 10, wherein the plurality of first shield electrodes is each provided between the plurality of first junction electrodes disposed side by side in the first direction.

12. The imaging device according to claim 9, wherein the plurality of second shield electrodes is provided on a side of the second substrate, and each has a planar shape having a longitudinal direction in the first direction of the first direction and the second direction that are substantially orthogonal to each other.

13. The imaging device according to claim 12, wherein the plurality of second shield electrodes is each provided between the plurality of second junction electrodes disposed side by side in the second direction.

14. The imaging device according to claim 9, wherein
the first substrate includes a first interlayer insulating film on the junction surface with the second substrate,
the second substrate includes a second interlayer insulating film on the junction surface with the first junction surface, and
ones of the plurality of first shield electrodes or the plurality of second shield electrodes are provided in a film of the first interlayer insulating film or the second interlayer insulating film, and another ones of the plurality of first shield electrodes or the plurality of second shield electrodes are exposed on a surface of the first interlayer insulating film or the second interlayer insulating film.

15. The imaging device according to claim 1, wherein the plurality of first junction electrodes is each disposed for one of the sensor pixels.

16. The imaging device according to claim 1, wherein the plurality of first junction electrodes is each disposed for four of the sensor pixels disposed in two rows by two columns.

17. The imaging device according to claim 1, further comprising a third substrate including a control circuit that controls the sensor pixels and the readout circuits, wherein the first substrate, the second substrate, and the third substrate are stacked in this order.
